(19) Europäisches Patentamt / European Patent Office / Office européen des brevets

(11) **EP 4 471 507 A2**

(12) **DEMANDE DE BREVET EUROPEEN**

(43) Date de publication:
**04.12.2024 Bulletin 2024/49**

(21) Numéro de dépôt: **24200105.5**

(22) Date de dépôt: **21.08.2020**

(51) Classification Internationale des Brevets (IPC):
**G04D 3/00** *(2006.01)*

(52) Classification Coopérative des Brevets (CPC):
**F16F 1/10; B33Y 80/00; G04B 17/066;**
**G04B 17/227; G04D 3/0069;** F16F 2226/02

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.09.2019 CH 11652019**

(62) Numéro(s) de document de la (des) demande(s) initiale(s) en application de l'article 76 CBE:
**21187318.7 / 3 915 788**
**20192120.2 / 3 845 770**

(71) Demandeur: **Sigatec SA**
**1950 Sion (CH)**

(72) Inventeurs:
• **Glassey, Marc-André**
**1967 Bramois (CH)**
• **Tille, Nicolas**
**1965 Savièse (CH)**

(74) Mandataire: **BOVARD AG**
**Patent- und Markenanwälte**
**Optingenstrasse 16**
**3013 Bern (CH)**

Remarques:
Cette demande a été déposée le 12.09.2024 comme demande divisionnaire de la demande mentionnée sous le code INID 62.

(54) **PROCÉDÉ DE FABRICATION D'UN LOT DE SPIRAUX HORLOGERS**

(57) Selon l'invention, un procédé de fabrication d'un lot de spiraux horlogers, dont les couples élastiques ont une moyenne dans une plage prédéterminée, comprend des étapes dans lesquelles :

d) dans une plaquette en un matériau à base de silicium, on réalise les spiraux horlogers selon des dimensions supérieures aux dimensions nécessaires pour l'obtention du lot de spiraux horlogers dont les couples élastiques ont la moyenne dans la plage prédéterminée,

w) plusieurs ou la totalité des spiraux horlogers sont soumis à une première oxydation de manière être transformés en spiraux horlogers oxydés superficiellement chacun dans une zone où, à partir du matériau à base de silicium, la première oxydation crée une portion de compensation thermique (50'a) pour modifier la sensibilité aux variations de température du couple élastique du spiral horloger correspondant, puis

e) à partir d'au moins une mesure sur au moins une partie des spiraux horlogers oxydés, on détermine la quantité de matériau à base de silicium à retirer des spiraux horlogers oxydés, pour obtenir le lot de spiraux horlogers ayant les couples élastiques dont la moyenne est dans la plage prédéterminée,

x) de la portion de compensation thermique (50'a) de plusieurs ou de la totalité des spiraux horlogers, on retire une épaisseur résiduaire qui correspond à la quantité de matériau à base de silicium à retirer, puis

y) plusieurs ou la totalité des spiraux horlogers oxydés sont soumis à une deuxième oxydation telle que la portion de compensation thermique soit régénérée.

FIG. 14B

## Description

Domaine technique de l'invention

La présente invention se rapporte au domaine de l'horlogerie. Plus précisément, elle concerne un procédé de fabrication d'un lot de spiraux horlogers, qui peuvent en particulier être des spiraux horlogers avec thermocompensation.

État de la technique

Dans un mouvement d'horlogerie, un oscillateur a pour fonction de fournir une fréquence de référence, à partir de laquelle est effectuée la mesure de l'écoulement du temps. Cet oscillateur est souvent appelé l'organe réglant du mouvement d'horlogerie. Il peut être mécanique en particulier lorsqu'il est prévu pour un mouvement d'horlogerie mécanique.

Un oscillateur mécanique classiquement utilisé en horlogerie résulte de l'association d'un spiral horloger et d'un balancier, qui est monté pivotant et qui joue le rôle d'un volant d'inertie, tandis que le spiral horloger est un ressort prévu pour produire un couple de rappel sur ce balancier.

Il y a quelques années, on a commencé d'utiliser de nouveaux matériaux pour la fabrication des spiraux horlogers, moyennant quoi de nouvelles techniques de fabrication telles que la gravure ionique réactive profonde (encore appelée gravure DRIE, qui est l'acronyme de Deep Reaction Ionique Etching) ont pu être employées.

Dans le document EP 1 422 436, il est proposé de fabriquer un spiral horloger qui comporte une âme en silicium et qui possède une compensation thermique grâce à un revêtement fait de dioxyde de silicium.

Fabriquer plusieurs spiraux horlogers dans une même plaquette, par gravage, permet de réduire les coûts de fabrication. Toutefois, on constate une dispersion géométrique entre des spiraux horlogers appartenant à des lots dont chacun est constitué de spiraux horlogers découpés tous selon le même motif, par gravure, dans une même plaquette.

A cet égard, le document EP 3 181 938 A1 propose un procédé de fabrication d'un spiral horloger ayant un couple élastique prédéterminé. Dans ce procédé, une ébauche de spiral horloger découpée selon des dimensions supérieures aux dimensions finales visées est ajustée après découpe par un retrait de matière sur une épaisseur calculée à partir d'une mesure sur l'ébauche de spiral horloger. La solution proposée dans ce document EP 3 181 938 donne des résultats suffisamment précis lorsqu'elle est appliquée individuellement, c'est-à-dire lorsqu'un seul spiral horloger est traité à la fois, ce qui est coûteux et compliqué à mettre en oeuvre. Lorsque la solution proposée dans EP 3 181 938 est appliquée collectivement à un lot de spiraux horlogers découpés par gravure dans une même plaque, un grand nombre des spiraux horlogers de ce lot ont un couple élastique si éloigné du couple élastique prédéterminé qu'ils sont inutilisables et constituent un rebus quantitativement très important et peu compatible, voire incompatible, avec les exigences de rentabilité d'une production industrielle.

Exposé sommaire de l'invention

L'invention a au moins pour but d'améliorer la précision de la fabrication d'un lot de spiraux horlogers dont les couples élastiques ont une moyenne dans une plage prédéterminée.

Selon l'invention, ce but est atteint grâce à un procédé de fabrication d'un lot de spiraux horlogers dont les couples élastiques ont une moyenne dans une plage prédéterminée.

Ce procédé de fabrication selon l'invention comprend des étapes dans lesquelles :

d) dans une plaquette en un matériau à base de silicium, on réalise les spiraux horlogers selon des dimensions supérieures aux dimensions nécessaires pour l'obtention du lot de spiraux horlogers dont les couples élastiques ont la moyenne dans la plage prédéterminée,

w) plusieurs ou la totalité des spiraux horlogers sont soumis à une première oxydation de manière être transformés en spiraux horlogers oxydés superficiellement chacun dans une zone où, à partir du matériau à base de silicium, la première oxydation crée une portion de compensation thermique (50) pour modifier la sensibilité aux variations de température du couple élastique du spiral horloger correspondant, puis

e) à partir d'au moins une mesure sur au moins une partie des spiraux horlogers oxydés, on détermine la quantité de matériau à base de silicium à retirer des spiraux horlogers oxydés, pour obtenir le lot de spiraux horlogers ayant les couples élastiques dont la moyenne est dans la plage prédéterminée,

x) de la portion de compensation thermique de plusieurs ou de la totalité des spiraux horlogers, on retire une épaisseur résiduaire qui correspond à la quantité de matériau à base de silicium à retirer, puis

y) plusieurs ou la totalité des spiraux horlogers oxydés sont soumis à une deuxième oxydation telle que la portion de compensation thermique soit régénérée.

Dans le procédé de fabrication selon l'invention, la ou les mesures employées à l'étape e) pour déterminer la quantité de matériau à base de silicium à retirer sont effectuées sur un ou des spiraux horlogers déjà pourvus chacun d'une portion de compensation thermique qui est prédéfinie. De la sorte, les couples élastiques des spiraux horlogers à l'issue du procédé de fabrication selon l'invention ont leur moyenne dans la plage prédéterminée, alors que ces spiraux horlogers sont chacun déjà pourvus de la portion de compensation thermique prédéfinie.

Dans l'étape x), l'épaisseur résiduaire retirée de la portion de compensation thermique correspond à la quantité de matériau à base de silicium à retirer et elle peut ne pas être égale à l'épaisseur de cette quantité de matériau à base de silicium à retirer.

En effet, l'épaisseur résiduaire retirée dans l'étape x) est faite du matériau à base de silicium oxydé, qui constitue la portion de compensation thermique et qui peut être du dioxyde de silicium dans le cas où le matériau à base de silicium est du silicium. En d'autres termes, l'épaisseur résiduaire retirée de la portion de compensation thermique dans l'étape x) n'est pas faite du même matériau que la quantité de matériau à base de silicium à retirer. L'épaisseur résiduaire retirée de la portion de compensation thermique dans l'étape x) est faite du matériau résultant de l'oxydation du matériau à base de silicium à retirer.

Dans le cas où le matériau à base de silicium à retirer est du silicium (dopé ou non dopé), l'épaisseur résiduaire retirée de la portion de compensation thermique dans l'étape x) est faite de dioxyde de silicium. Dans le cas où le matériau à base de silicium à retirer est du silicium (dopé ou non dopé), l'épaisseur résiduaire retirée de la portion de compensation thermique dans l'étape x) est égale à environ 227% de l'épaisseur de la quantité de matériau à base de silicium à retirer.

L'épaisseur résiduaire retirée dans l'étape x) résiduaire est telle que la quantité du matériau à base de silicium consommée lors d'une deuxième oxydation régénérant la portion de compensation thermique à l'étape y) soit égale à la quantité de matériau à base de silicium à retirer dans l'étape x).

Avantageusement, dans l'étape d), on réalise les spiraux horlogers par gravure.

Avantageusement, l'étape d) est réalisée par gravure ionique réactive profonde.

Avantageusement, l'étape w) est réalisée collectivement sur les spiraux horlogers encore attachés à la plaquette.

Avantageusement, l'étape x) est réalisée collectivement sur les spiraux horlogers encore attachés à la plaquette.

Avantageusement, l'étape y) est réalisée collectivement sur les spiraux horlogers encore attachés à la plaquette.

Avantageusement, dans l'étape e), la quantité de matériau à base de silicium à retirer est déterminée à partir d'une mesure effectuée sur un échantillon sacrificiel prélevé parmi les spiraux horlogers de la plaquette et qui est dissocié de la plaquette.

Avantageusement, dans l'étape e), la quantité de matériau à base de silicium à retirer est déterminée au moyen d'une table de correspondance indiquant l'épaisseur de matériau à base de silicium à retirer pour chacun de plusieurs couples élastiques moyens ou pour chacune de plusieurs grandeurs liées à de tels couples élastiques moyens.

Avantageusement, la quantité de matériau à base de silicium à retirer est une épaisseur de matériau à base de silicium à retirer sur les spiraux horlogers réalisés à l'étape d).

Avantageusement, le matériau à base de silicium est du silicium, par exemple du silicium dopé.

L'invention et une autre invention peuvent être combinées et sont respectivement appelées la première invention et la deuxième invention dans ce qui suit.

La deuxième invention a au moins pour but de permettre qu'une dispersion géométrique entre des spiraux horlogers puisse être réduite collectivement sur plusieurs spiraux horlogers découpés par gravure dans une même plaquette.

Selon la deuxième invention, ce but est atteint grâce à un procédé de fabrication de spiraux horlogers dans une plaquette, comprenant une étape dans laquelle :

b) entre au moins une source émettant un rayonnement et une résine photosensible portée par une face de la plaquette, un masque réutilisable stoppe au moins une partie du rayonnement sauf au niveau de zones comprenant plusieurs fenêtres qui définissent les contours des spiraux horlogers et que comporte ce masque réutilisable.

Selon la deuxième invention, le masque réutilisable est un masque réutilisable corrigé en ce qu'au moins une partie des fenêtres sont différentes dimensionnellement entre elles de manière à réduire une étendue d'une dispersion des couples élastiques d'une partie au moins des spiraux horlogers réalisés dans la même plaquette.

Le procédé de fabrication selon la deuxième invention peut incorporer une ou plusieurs autres caractéristiques avantageuses, isolément ou en combinaison, en particulier parmi celles définies ci-après.

Avantageusement, le procédé de fabrication selon la deuxième invention comprend des étapes qui suivent l'étape b) et dans lesquelles :

c) à partir de la résine photosensible, on réalise un masque sacrificiel sur la plaquette en retirant de la plaquette la résine photosensible ayant été irradiée par le rayonnement à l'étape b) ou la résine photosensible ayant été soustraite au rayonnement à l'étape b) par le masque réutilisable corrigé,

d) dans la plaquette, on réalise par gravure les spiraux horlogers à l'aide du masque sacrificiel.

Avantageusement, le procédé de fabrication selon la deuxième invention est un procédé de fabrication d'un lot de spiraux horlogers dont les couples élastiques ont une moyenne dans une plage prédéterminée. Avantageusement, dans l'étape d), on réalise les spiraux horlogers selon des dimensions supérieures aux dimensions nécessaires pour l'obtention du lot de spiraux horlogers dont les couples élastiques ont la moyenne dans la plage prédéterminée. Avantageusement, le procédé de fabrication comprend des étapes qui suivent l'étape d) et dans lesquelles :

    e) on détermine la quantité de matière à retirer des spiraux horlogers réalisés à l'étape d), pour obtenir le lot de spiraux horlogers ayant les couples élastiques dont la moyenne est dans la plage prédéterminée,

    f) de plusieurs ou de la totalité des spiraux horlogers réalisés à l'étape d), on retire ladite quantité de matière à retirer.

Avantageusement, l'étape f) est réalisée collectivement sur les spiraux horlogers encore attachés à la plaquette.

Avantageusement, dans l'étape e), la quantité de matière à retirer est déterminée à partir d'une mesure effectuée sur un échantillon sacrificiel prélevé parmi les spiraux horlogers de la plaquette et qui est dissocié de la plaquette.

Avantageusement, dans l'étape e), la quantité de matière à retirer est déterminée au moyen d'une table de correspondance indiquant l'épaisseur de matière à retirer pour chacun de plusieurs couples élastiques moyens ou pour chacune de plusieurs grandeurs liées à de tels couples élastiques moyens.

Avantageusement, la quantité de matière à retirer est une épaisseur de matière à retirer sur les spiraux horlogers réalisés à l'étape d).

Avantageusement, la plaquette est faite d'un matériau à base de silicium, l'étape f) comprenant des sous-étapes dans lesquelles :

    f1) plusieurs ou la totalité des spiraux horlogers réalisés à l'étape d) sont soumis à une oxydation de manière être transformés en spiraux horlogers oxydés superficiellement sur une épaisseur qui est l'épaisseur de matière à retirer déterminée à l'étape e),

    f2) des spiraux horlogers oxydés superficiellement, on retire le matériau à base de silicium qui a été oxydé lors de la sous-étape f1).

Avantageusement, l'étape d) est réalisée par gravure ionique réactive profonde.

Avantageusement, le procédé de fabrication selon la deuxième invention comprend une étape dans laquelle :
g) sur chacun de plusieurs ou de la totalité des spiraux horlogers, on forme une portion de compensation thermique modifiant la sensibilité aux variations de température du couple élastique du spiral horloger correspondant.

Avantageusement, le procédé de fabrication comprend une étape préparatoire qui précède l'étape b) et dans laquelle :

    a) on élabore le masque réutilisable corrigé.

Avantageusement, l'étape préparatoire comporte des sous-étapes dans lesquelles :

    a1) on réalise une cartographie de degrés de correction à appliquer en des positions différentes sur un plan de plaquette pour réduire une hétérogénéité spatiale d'une gravure réalisée par un dispositif de gravure,

    a2) on réalise le masque réutilisable corrigé de telle manière que les fenêtres soient dimensionnées en fonction de la cartographie réalisée à la sous-étape a1).

Avantageusement, dans la sous-étape a1), on effectue ce qui suit :

    a11) entre au moins la source et une résine photosensible portée par une face d'une plaquette de test, un masque non corrigé stoppe au moins une partie du rayonnement de la source sauf au niveau de zones comprenant plusieurs fenêtres qui définissent les contours de structures de test et qui sont distantes entre elles au sein du masque non corrigé,

    a12) on retire de la plaquette de test la résine photosensible ayant été irradiée par le rayonnement ou la résine photosensible ayant été soustraite au rayonnement par le masque non corrigé,

    a13) dans la plaquette de test, on réalise par gravure les structures de test en des positions différentes,

    a14) on effectue des mesures pour correction sur les structures de test, on détermine des degrés de correction à partir de ces mesures pour correction et, à ces degrés de correction, on attribue des localisations sur un plan de plaquette en fonction des positions des structures de test.

Avantageusement, les structures de test sont des spiraux horlogers de test.

Avantageusement, les mesures pour correction comprennent des mesures des fréquences d'oscillateurs chacun comprenant un balancier d'inertie prédéterminée et un des spiraux horlogers de test.

Avantageusement, les fenêtres du masque non corrigé sont dimensionnellement identiques entre elles.

Avantageusement, dans la sous-étape a2), on réalise le masque réutilisable corrigé de telle manière que, en plus d'être dimensionnées en fonction de la cartographie réalisée à la sous-étape a1), les fenêtres soient dimensionnées pour qu'à l'étape d), les spiraux horlogers soient réalisés selon des dimensions supérieures aux dimensions nécessaires pour l'obtention du lot de spiraux horlogers dont les couples élastiques ont la moyenne dans la plage prédéterminée.

Avantageusement, le procédé de fabrication selon la deuxième invention est un procédé de fabrication d'un lot de spiraux horlogers selon la première invention.

Avantageusement, le procédé de fabrication selon la deuxième invention comprend une étape qui suit l'étape b) et dans laquelle :

c) à partir de la résine photosensible, on réalise un masque sacrificiel sur la plaquette en retirant de la plaquette la résine photosensible ayant été irradiée par le rayonnement à l'étape b) ou la résine photosensible ayant été soustraite au rayonnement à l'étape b) par le masque réutilisable corrigé.

Avantageusement, on réalise l'étape d) à l'aide du masque sacrificiel.

Avantageusement, le procédé de fabrication selon la deuxième invention comprend une étape préparatoire qui précède l'étape b) et dans laquelle :

a) on élabore le masque réutilisable corrigé.

Avantageusement, l'étape préparatoire comporte des sous-étapes dans lesquelles :

a1) on réalise une cartographie de degrés de correction à appliquer en des positions différentes sur un plan de plaquette pour réduire une hétérogénéité spatiale d'une gravure réalisée par un dispositif de gravure,

a2) on réalise le masque réutilisable corrigé de telle manière que les fenêtres soient dimensionnées en fonction de la cartographie réalisée à la sous-étape a1).

Avantageusement, dans la sous-étape a1), on effectue ce qui suit :

a11) entre au moins la source et une résine photosensible portée par une face d'une plaquette de test, un masque non corrigé stoppe au moins une partie du rayonnement de la source sauf au niveau de zones comprenant plusieurs fenêtres qui définissent les contours de structures de test et qui sont distantes entre elles au sein du masque non corrigé,

a12) on retire de la plaquette de test la résine photosensible ayant été irradiée par le rayonnement ou la résine photosensible ayant été soustraite au rayonnement par le masque non corrigé,

a13) dans la plaquette de test, on réalise par gravure les structures de test en des positions différentes,

a14) on effectue des mesures pour correction sur les structures de test, on détermine des degrés de correction à partir de ces mesures pour correction et, à ces degrés de correction, on attribue des localisations sur un plan de plaquette en fonction des positions des structures de test.

Avantageusement, les structures de test sont des spiraux horlogers de test.

Avantageusement, les mesures pour correction comprennent des mesures des fréquences d'oscillateurs chacun comprenant un balancier d'inertie prédéterminée et un des spiraux horlogers de test.

Avantageusement, les fenêtres du masque non corrigé sont dimensionnellement identiques entre elles.

Avantageusement, dans la sous-étape a2), on réalise le masque réutilisable corrigé de telle manière que, en plus d'être dimensionnées en fonction de la cartographie réalisée à la sous-étape a1), les fenêtres soient dimensionnées pour qu'à l'étape d), les spiraux horlogers soient réalisés selon des dimensions supérieures aux dimensions nécessaires pour l'obtention du lot de spiraux horlogers dont les couples élastiques ont la moyenne dans la plage prédéterminée.

Brève description des dessins

D'autres avantages et caractéristiques ressortiront plus clairement de la description qui va suivre de modes particuliers de réalisation donnés à titre d'exemples non limitatifs et représentés aux dessins annexés, parmi lesquels :

- la figure 1 est une vue en perspective de l'un de plusieurs spiraux horlogers réalisés dans une plaquette en mettant en oeuvre un procédé de fabrication selon un premier mode de réalisation de la deuxième invention,

- la figure 2 est un oscillateur mécanique comprenant le spiral horloger représenté à la figure 1,

- la figure 3 est un schéma synoptique d'un procédé de fabrication selon un premier mode de réalisation de la deuxième invention,

- la figure 4 est une vue schématique, en perspective, illustrant une étape du procédé de fabrication de la figure 3,

- la figure 5 est une vue schématique et partielle, en coupe, et illustre une étape du procédé de fabrication de la figure 3,

- la figure 6 est une vue schématique, en perspective, illustrant un état intermédiaire entre deux étapes du procédé de fabrication de la figure 3,

- la figure 7 est une vue schématique, en perspective, d'une plaquette et d'un ensemble de spiraux horlogers ayant été découpés en même temps par gravure tous dans cette plaquette, lors de la mise en oeuvre du procédé de fabrication de la figure 3,

- la figure 8 est une vue schématique d'une cartographie de degrés de correction dimensionnel à appliquer en des emplacements différents sur un plan de plaquette pour réduire l'hétérogénéité d'une gravure réalisée par un dispositif de gravure,

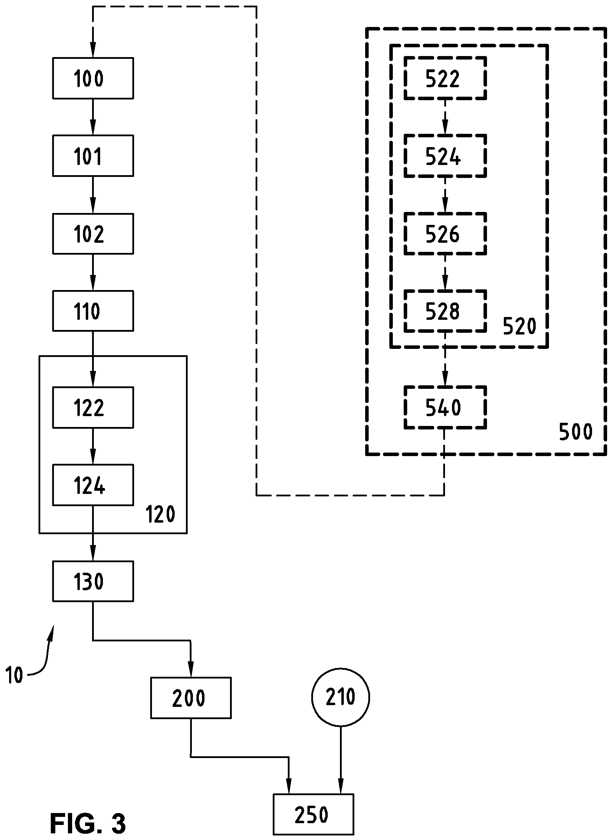

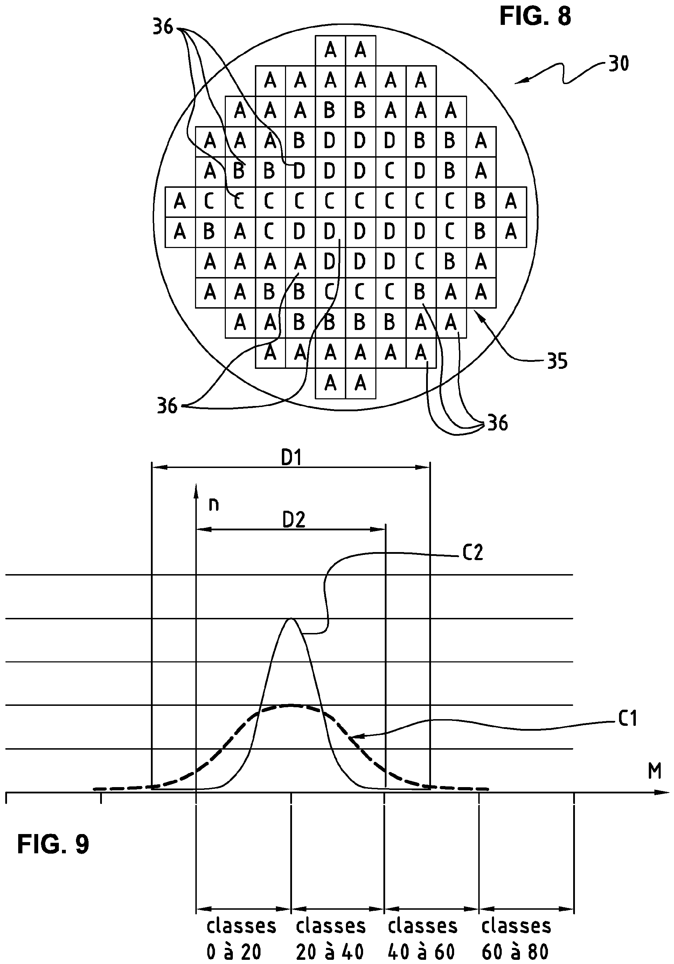

- la figure 9 est un graphique double où une première courbe est la représentation graphique (répartition de couples élastiques) du nombre n de spiraux horlogers en fonction du couple élastique M, parmi un ensemble de spiraux horlogers découpés collectivement par gravure dans une même plaquette sans mettre en oeuvre la deuxième invention, et où une deuxième courbe est la représentation graphique (répartition de couples élastiques) du nombre n de spiraux horlogers en fonction du couple élastique M, parmi un ensemble de spiraux horlogers découpés collectivement par gravure dans une même plaquette au moyen du procédé de fabrication de la figure 3,

- la figure 10A est une section transversale, schématique, d'un brin élastiquement flexible d'un spiral horloger entre deux étapes du procédé de fabrication de la figure 3,

- la figure 10B est une section transversale, schématique, d'un brin élastiquement flexible d'un spiral horloger entre deux étapes du procédé de fabrication de la figure 3,

- la figure 10C est une section transversale, schématique, d'un brin élastiquement flexible d'un spiral horloger entre deux étapes du procédé de fabrication de la figure 3,

- la figure 11A est un graphique triple où chacune de trois courbes est la représentation graphique (répartition de couples élastiques) du nombre n de spiraux horlogers en fonction du couple élastique M, parmi un ensemble de spiraux horlogers réalisés collectivement dans une même plaquette en mettant en oeuvre incomplètement le procédé de fabrication de la figure 3,

- la figure 11B est un graphique triple où chacune de trois courbes est la représentation graphique (la répartition de couples élastiques) du nombre n de spiraux horlogers en fonction du couple élastique M, parmi un ensemble de spiraux horlogers réalisés collectivement dans une même plaque en mettant en oeuvre complètement le procédé de la figure 3, y compris des étapes réalisant une correction par enlèvement de matière par rapport aux spiraux horlogers mesurés pour établir les trois répartitions de couple élastique représentées à la figure 11A, et

- la figure 12 est une section transversale, schématique, d'un brin élastiquement flexible d'un spiral horloger totalement terminé, une fois mises en oeuvre toutes les étapes du procédé de fabrication de la figure 3,

- la figure 13 est un schéma synoptique d'un procédé de fabrication qui est selon un deuxième mode de réalisation de la deuxième invention et qui comprend un procédé de fabrication selon la première invention,

- la figure 14A est une section transversale, schématique, d'un brin élastiquement flexible d'un spiral horloger entre deux étapes du procédé de fabrication de la figure 13,

- la figure 14B est une section transversale, schématique, d'un brin élastiquement flexible d'un spiral horloger entre deux étapes du procédé de fabrication de la figure 13,

- la figure 14C est une section transversale, schématique, d'un brin élastiquement flexible d'un spiral horloger entre deux étapes du procédé de fabrication de la figure 13,

- la figure 14D est une section transversale, schématique, d'un brin élastiquement flexible d'un spiral horloger totalement terminé, une fois mises en oeuvre toutes les étapes du procédé de fabrication de la figure 13.

Description de modes préférentiels de réalisation des inventions

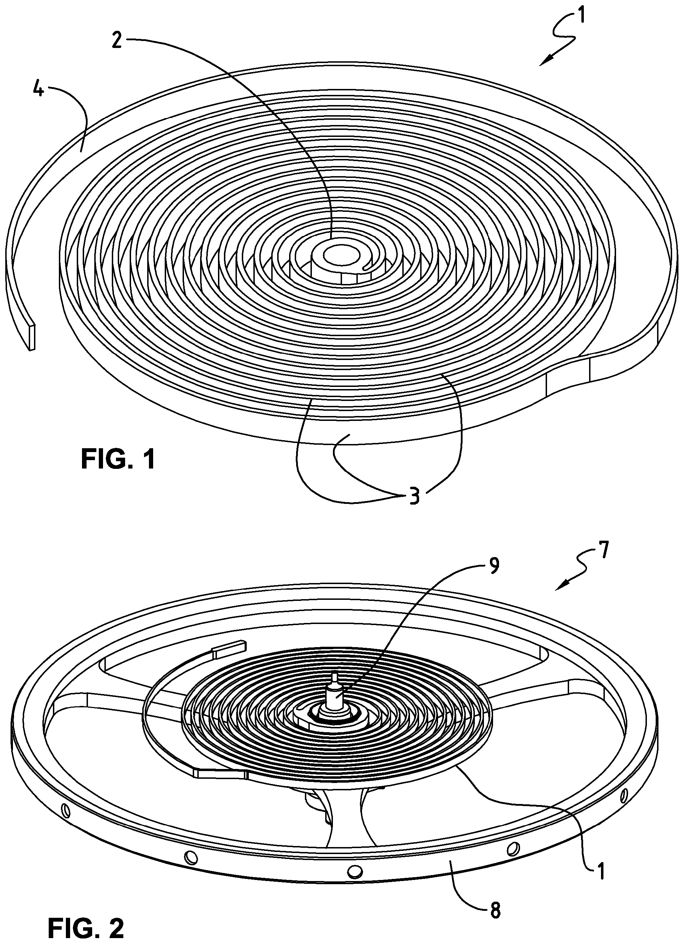

Sur la figure 1 est représenté un spiral horloger 1, qui comporte une virole 2 destinée à être solidarisée à un arbre pivotant. Le spiral horloger 1 comporte également un brin élastiquement flexible 3 se raccordant par une extrémité sur la virole 2 et enroulé selon une spirale de manière à former plusieurs spires consécutives, dont la dernière est prolongée par un segment d'attache 4 destiné à être attaché à un pont de balancier fixe (non représenté), par exemple par l'intermédiaire d'un piton (non représenté).
Sur la figure 2 est représenté un oscillateur mécanique 6, qui est d'un type appelé « balancier-spiral » et qui comporte le spiral horloger 1, un balancier 8 et un arbre 9 portant ce balancier 8 ainsi que la virole 2. Dans l'oscillateur mécanique 6, le spiral horloger 1 est accouplé au balancier 8 par le fait que la virole 2 et le balancier 8 sont tous deux solidaires de l'arbre 9.

Le spiral horloger 1 fait partie d'un lot de spiraux horlogers 1 que l'on a réalisé dans une même plaquette en mettant en oeuvre un procédé de fabrication 10 selon un premier mode de réalisation de la deuxième invention, qui présente de nombreux avantages. Ce procédé de fabrication 10 comporte plusieurs étapes se succédant comme représenté sur la figure 3.

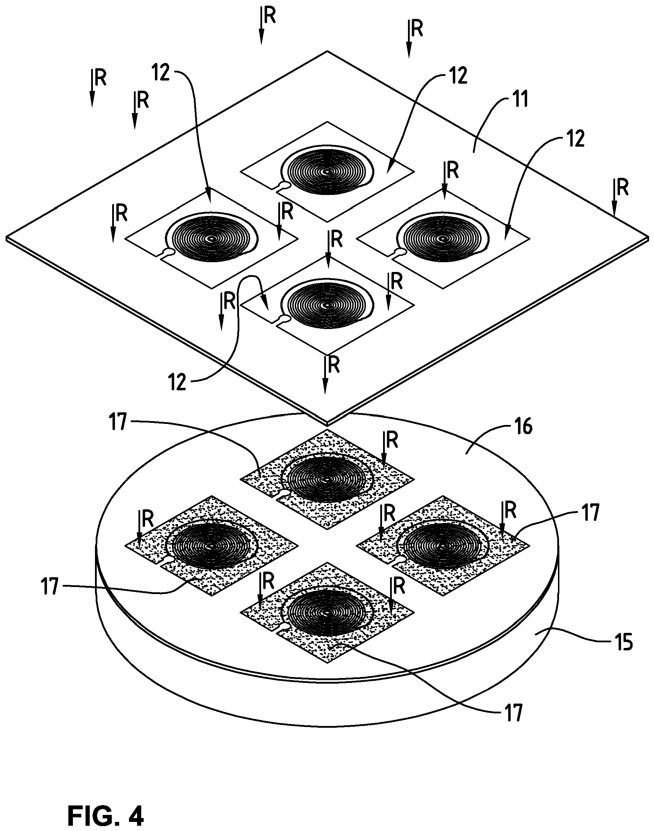

Dans le procédé de fabrication 10, on utilise un masque réutilisable corrigé 11, visible à la figure 4. Ce masque réutilisable corrigé 11 comporte plusieurs fenêtres 12 qui définissent les contours de spiraux horlogers. Dans le procédé de fabrication 10, les fenêtres 12 définissent les contours externes de spiraux horlogers. En variante, les fenêtres 12 pourraient définir les contours internes de spiraux horlogers (en fonction du type de résine photosensible employé, voir plus loin).

Dans l'exemple représenté à la figure 4, les fenêtres 12 sont au nombre de 4, grâce à quoi cette figure 4 est simplifiée et plus de détails peuvent y figurer. Bien entendu, le nombre des fenêtres 12 peut être différent de 4. Le nombre des fenêtres 12 dans le masque réutilisable corrigé 11 peut être de plusieurs dizaines. De préférence, le nombre de fenêtres 12 dans le masque réutilisable corrigé 11 est supérieur à 100. De manière encore plus préférée, le nombre de fenêtres 12 dans le masque réutilisable corrigé 11 est de plusieurs centaines.

Le masque réutilisable corrigé 11 sert dans une photolithographie faisant partie du procédé de fabrication 10. Sauf au niveau des fenêtres 12, le masque réutilisable corrigé 11 forme un écran à même de stopper au moins une partie d'un rayonnement destiné à transformer une résine photosensible. En d'autres termes, au moins une partie d'un tel rayonnement est stoppée par le masque réutilisable corrigé 11 sauf au niveau des fenêtres 12.

Dans le premier mode de réalisation de la deuxième invention décrit ici, les fenêtres 12 sont les seules zones où le masque réutilisable corrigé 11 ne forme pas un écran à même de stopper au moins une partie d'un rayonnement destiné à transformer une résine photosensible. Toutefois, il pourrait en être autrement sans sortir du cadre de la deuxième invention. Par exemple, en plus des fenêtres 12, le masque réutilisable corrigé pourrait comporter une ou plusieurs zones qui définissent les contours (internes et/ou externes) de structures de caractérisation et où est absent l'écran à même de stopper au moins une partie d'un rayonnement destiné à transformer une résine photosensible. De telles structures de caractérisation peuvent être différentes des spiraux horlogers 1 et pourront servir pour quantifier une gravure en étant mesurés et pour déterminer un niveau d'ajustement à effectuer par retrait de matière sur les spiraux horlogers 1, d'une manière qui sera expliquée plus loin.

Le masque réutilisable corrigé 11 peut comporter une plaque de verre qui est transparent de manière à pouvoir être traversé par le rayonnement susmentionné et dont une des deux faces principales porte un revêtement à base de chrome sauf en certaines zones comprenant les fenêtres 12. Le revêtement à base de chrome est à même de stopper tout ou partie du rayonnement susmentionné. Chaque fenêtre 12 est une zone où ce revêtement à base de chrome est absent.

Lorsqu'on dispose du masque réutilisable corrigé 11, la première étape du procédé de fabrication 10 est l'étape 100, qui est celle illustrée à la figure 4.

Sur la figure 4, un wafer 15 comporte deux faces principales dont une est recouverte d'une résine photosensible 16. Comme cela sera expliqué plus loin, le wafer 15 est une structure multicouche, ce qui n'est pas représenté à la figure 4 dans un souci de clarté. Dans le procédé de fabrication 10, le wafer 15 est une structure multicouche, mais il pourrait en être autrement. En particulier, le wafer 15 pourrait être monocouche et constitué de la plaquette qui, plus loin, est référencée 22.

Toujours sur la figure 4, le masque réutilisable corrigé 11 est placé entre une source émettant un rayonnement R et l'ensemble constitué par la résine photosensible 16 et le wafer 15. Le rayonnement R peut notamment être un rayonnement comprenant des UV, c'est-à-dire des ultra-violets, voire être constitué d'UV.

Au moins une partie du rayonnement R est à même de transformer la résine photosensible 16 de manière à la rendre soluble ou insoluble dans un bain chimique approprié. Dans le procédé de fabrication 10, la résine photosensible 16 est choisie de manière que son irradiation par le rayonnement R rende cette résine photosensible 16 soluble dans un bain chimique approprié. Dans une variante, la résine photosensible est choisie de manière que son irradiation par un rayonnement analogue ou identique au rayonnement R rende cette résine photosensible non soluble dans un bain chimique approprié, auquel cas le masque réutilisable corrigé 11 est transformé en conséquence.

Dans l'étape 100, le masque réutilisable corrigé 11 stoppe le rayonnement R sauf au niveau des fenêtres 12. De la sorte, la résine photosensible 16 est irradiée dans les zones en regard des fenêtres 12. La référence 17 désigne la résine photosensible 16 qui a été irradiée par le rayonnement R à travers les fenêtres 12 et qui est devenue ainsi soluble dans un bain chimique approprié.

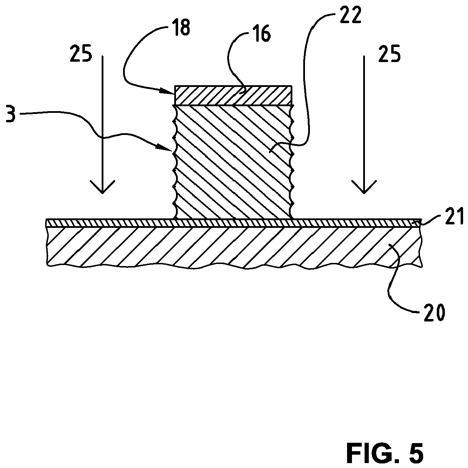

Ainsi qu'on peut le voir à la figure 3, une étape 101 succède à l'étape 100. Dans l'étape 101, on retire la résine photosensible irradiée 17 en la solubilisant dans un bain chimique approprié, ce qu'on appelle le développement. La résine photosensible 16 qui n'a pas été irradiée et transformée par le rayonnement R résiste au bain chimique, reste ainsi en place sur le wafer 15 et forme un masque sacrificiel, qui est référencé 18 à la figure 5. En d'autres termes, on réalise le masque sacrificiel 18 dans l'étape 101.

L'étape référencée 102 à la figure 3 suit l'étape 101. L'étape 102 est illustrée à la figure 5, sur laquelle on peut voir que la structure multicouche du wafer 15 comporte un support 20, une couche d'arrêt 21 et une plaquette 22. La plaquette 22 est faite d'un matériau à même d'être gravé, par exemple d'un matériau à base de silicium. De préférence, la plaquette 22 est faite de silicium. Le silicium de la plaquette 22 peut être polycristallin. De préférence, la plaquette 22 est faite de silicium monocristallin. Le silicium de la plaquette 22 peut ne pas être dopé. De préférence, la plaquette 22 est faite de silicium dopé, qui est électriquement conducteur, plus stable dimensionnellement et de meilleure résistance mécanique. De préférence, la plaquette 22 est faite de silicium dopé au phosphore. De préférence, la plaquette 22 est faite de silicium qui est d'orientation {1,1,1} et/ou qui est dopé. De préférence, la plaquette 22 est faite de silicium qui est d'orientation <1,1,1> et/ou qui est dopé de manière à posséder une résistivité inférieure ou égale à 0,1 $\Omega.cm^{-1}$, par exemple une résistivité égale à 0,05 $\Omega.cm^{-1}$.

De préférence, le wafer 11 est de type silicium-oxyde de silicium-silicium, c'est-à-dire du type désigné communément par l'acronyme anglais « SOI ». Tel est le cas dans le procédé de fabrication 10. Dans le procédé de fabrication 10, le support 20 est fait de silicium, la couche d'arrêt 21 est faite de dioxyde de silicium et la plaquette 22 est faite de silicium.

Dans l'étape 102, plusieurs spiraux horlogers 1 sont découpés collectivement, ensemble et en même temps, tous dans la plaquette 22, au moyen d'une gravure 25, qui est une gravure directionnelle se produisant là où la plaquette 22 n'est pas protégée par le masque sacrificiel 18. Dans procédé de fabrication 10, la gravure 25 est une gravure ionique réactive profonde, encore appelée gravure DRIE (acronyme de « deep reaction ion etching », qui est la désignation anglaise de la gravure ionique réactive profonde) ou gravure selon le procédé Bosch. Derrière le masque sacrificiel 18, la plaquette 22 n'est pas gravée. La couche d'arrêt 21 est insensible à la gravure 25 qui ne l'entame donc pas. La couche d'arrêt 21 a donc pour fonction d'arrêter la gravure 25.

Le masque sacrificiel 18 est sacrificiel dans la mesure où il est éphémère et où il est détruit une fois la gravure 25 terminée.

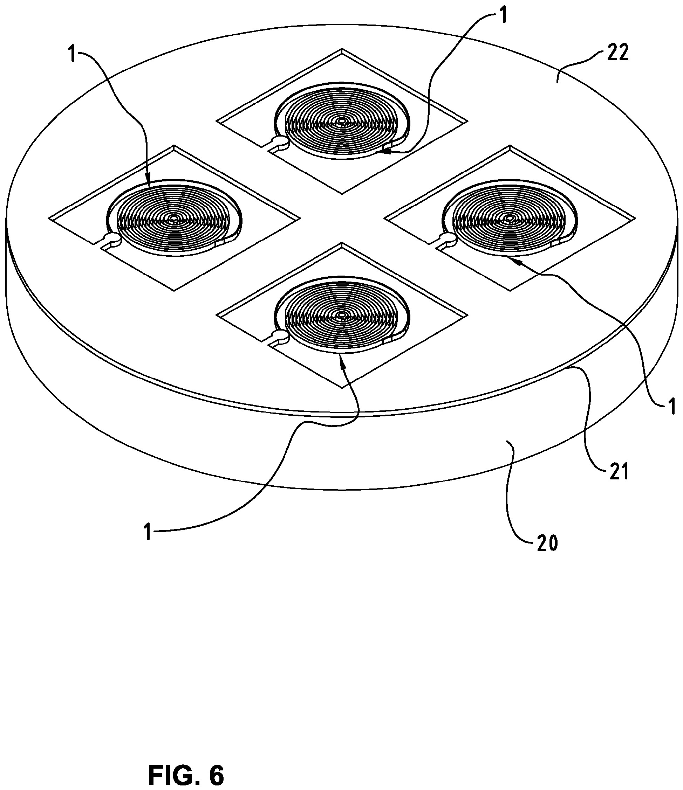

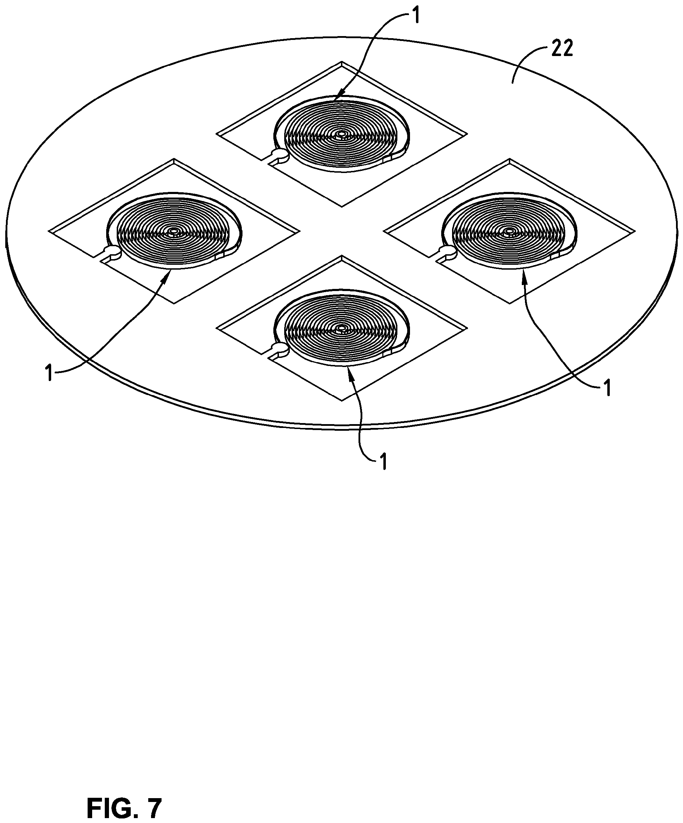

La figure 6 représente l'état du wafer 15 une fois que la gravure 25 est terminée. Sur cette figure 6, la plaquette 22 et les spiraux horlogers 1 découpés dedans sont toujours liés au support 20 par la couche d'arrêt 21. Le support 20 et la couche d'arrêt 21 peuvent être retirés localement. Dans le procédé de fabrication 10, le support 20 et la couche d'arrêt 21 sont supprimés totalement, par exemple par gravure, de manière que soient libérés les spiraux horlogers 1 et la plaquette 22, après quoi la plaquette 22 et les spiraux horlogers 1 découpés dedans sont tels que représentés à la figure 7.

Sur la figure 7, les spiraux horlogers 1 découpés dans la plaquette 22 sont toujours attachés à cette plaquette 22, si bien qu'on peut facilement les déplacer ensemble et les traiter collectivement et en même temps.

Le masque réutilisable corrigé 11 est corrigé en ce qu'au moins une partie des fenêtres 12 sont différentes dimensionnellement entre elles de manière à réduire une étendue d'une dispersion des couples élastiques des spiraux horlogers 1 découpés par gravure dans la même plaquette 12.

Il a en effet été découvert que, si le masque réutilisable n'est pas corrigé, c'est-à-dire si toutes ses fenêtres analogues aux fenêtres 12 sont identiques dimensionnellement entre elles, les couples élastiques des spiraux horlogers découpés dans une même plaquette 22 par gravure DRIE à l'aide d'un masque sacrificiel formé au moyen de ce masque réutilisable non corrigé ont des valeurs très dispersées, et l'étendue de la dispersion de ces couples élastiques est importante. On pense que cela est dû aux imperfections de la chambre de gravure (répartition non uniforme des plasmas/gaz).

Sur le graphe de la figure 9, le couple élastique M est en abscisse, tandis que des nombres n de spiraux horlogers parmi tous les spiraux horlogers réalisés dans une même plaquette 22 sont en ordonnée. Toujours sur le graphe de la figure 9, les courbes C1 et C2 sont normalement des histogrammes mais elles ont été lissées dans un souci de clarté. Encore sur le graphe de la figure 9, des classes croissantes de couple élastique sont également indiquées le long de l'axe des abscisses. Dans l'exemple représenté sur la figure 9, le nombre de classes est égal à 80, mais il pourrait être autre moyennant une autre segmentation en classes. Par exemple, le nombre de classes pourrait être égal à 20 comme c'était l'usage autrefois.

Sur la figure 9, la courbe C1 est la représentation graphique de la dispersion des couples élastiques de spiraux horlogers réalisés dans une même plaquette 22 en utilisant un masque réutilisable non corrigé.

Toujours sur la figure 9, la courbe C2 est la représentation graphique de la dispersion des couples élastiques des spiraux horlogers 1 réalisés dans une même plaquette 22 en employant le masque réutilisable corrigé 11, lors d'une mise en oeuvre du procédé de fabrication 10.

Dit de manière simplifiée, la correction qu'intègre le masque réutilisable corrigé 11 permet de passer de la courbe C1 à la courbe C2.

Sur la figure 9, on voit que l'écart-type associé à la courbe C1 est bien plus élevé que l'écart-type associé à la courbe C2. En d'autres termes, l'étendue D1 de la dispersion des couples élastiques des spiraux horlogers réalisés dans une même plaquette au moyen d'un masque réutilisable non corrigé est grande. L'étendue D2 de la dispersion des couples élastiques des spiraux horlogers 1 réalisés dans une même plaquette 22 au moyen du masque réutilisable corrigé 11 est nettement plus petite que l'étendue D1.

En particulier, l'étendue D2 est suffisamment petite pour que tous ou pratiquement tous les spiraux horlogers 1 réalisés dans une même plaquette 22 au moyen du masque réutilisable corrigé 11 puissent être classés dans un nombre réduit de classes et appariés avec des balanciers répartis dans un nombre réduit de

EP 4 471 507 A2

classes.

Une classe de spiraux horlogers est destinée à recevoir tous les spiraux horlogers ayant un couple élastique situé entre deux bornes prédéfinies. Une classe de balanciers est destinée à recevoir tous les balanciers ayant une inertie située entre deux bornes prédéfinies. En appairant n'importe quel spiral horloger et n'importe balancier appartenant à des classes correspondantes, on obtient un oscillateur mécanique qui est prêt à être monté dans un mouvement horloger dans la mesure où le réglage final de cet oscillateur mécanique peut être effectué au moyen d'une raquetterie ou en jouant sur l'inertie du balancier, alors que l'oscillateur mécanique est en place dans le mouvement horloger.

Le masque réutilisable corrigé 11 est réalisé lors d'une étape préparatoire 500. Comme le masque réutilisable corrigé 11 est réutilisable et peut servir un très grand nombre de fois, l'étape préparatoire 500 peut n'être réalisée qu'une une seule fois pour toutes, après quoi on peut réaliser un très grand nombre de fois le procédé de fabrication 10 commençant directement par l'étape 100, sans refaire l'étape préparatoire 500.

Le masque réutilisable corrigé 11 convient pour une installation de gravure spécifique, à savoir l'installation de gravure avec et pour laquelle il a été élaboré. Cette installation de gravure peut évoluer dans le temps. A partir des mesures effectuées sur les spiraux horlogers 1 réalisés au moyen de l'installation de gravure, il est possible de détecter une évolution nécessitant de concevoir et réaliser un nouveau masque réutilisable corrigé 11.

L'étape préparatoire 500 comprend une sous-étape 520, dans laquelle on réalise une cartographie de degrés de correction à appliquer en de positions différentes sur un plan de plaquette pour réduire une hétérogénéité spatiale d'une gravure réalisée par le dispositif de gravure. Une telle cartographie 30 est représentée sur la figure 8.

La sous-étape 520 comporte une opération 522, qui est identique à l'étape 100 sauf que la plaquette 22 est remplacée par une plaquette de test et sauf qu'on utilise un masque non corrigé à la place du masque réutilisable corrigé 11. Ce masque non corrigé sert dans une photolithographie. Dans ce masque non corrigé, il y a des fenêtres qui, comme les fenêtres 12, sont des zones où il n'y a pas d'écran à même de stopper au moins une partie du rayonnement R. Les fenêtres du masque non corrigé définissent les contours (internes et/ou externes) de spiraux horlogers de test ou les contours (internes et/ou externes) d'autres structures de test. Dans le procédé de fabrication 10, les fenêtres du masque non corrigé sont dimensionnellement identiques entre elles et définissent les contours de spiraux horlogers de test.

Lors de l'opération 522, le masque non corrigé se trouve entre la source émettant le rayonnement R dans l'installation de gravure considérée et une résine photosensible portée par une face de la plaquette de test. Toujours dans l'opération 522, le masque corrigé stoppe au moins une partie du rayonnement de la source sauf au niveau des fenêtres, en regard desquelles la résine photosensible est irradiée et transformée. Dans le procédé de fabrication 10, la résine photosensible est choisie de manière que son irradiation par le rayonnement R rende cette résine photosensible soluble dans un bain chimique approprié. Dans une variante, la résine photosensible est choisie de manière que son irradiation par un rayonnement analogue ou identique au rayonnement R rende cette résine photosensible non soluble dans un bain chimique approprié, auquel cas le masque réutilisable non corrigé est transformé en conséquence.

Toujours dans la sous-étape 520, une opération 524 suit l'opération 522. L'opération 524 est identique à l'étape 101 sauf que la résine photosensible que l'on retire alors est celle qui a été irradiée lors de l'opération 522 et que porte la plaquette de test. Dans l'opération 524, on forme donc un masque sacrificiel à partir de la résine photosensible.

Dans la sous-étape 520, une opération 526 suit l'opération 524. L'opération 526 est identique à l'étape 102 sauf que le découpage par gravure dans cette opération 526 est un découpage de spiraux horlogers de test et qu'il est effectué au moyen du masque sacrificiel réalisé lors de l'opération 524. Dans l'opération 526, on découpe des spiraux horlogers de test dans une même plaquette de test, par gravure DRIE, dans l'installation de gravure, en des positions réparties sur un plan de plaquette.

Dans la sous-étape 520, une opération 528 suit l'opération 526. Dans l'opération 528, on effectue des mesures pour correction sur les spiraux horlogers de test réalisés dans la plaquette de test lors de l'opération 526. De préférence, ces mesures pour correction sont des mesures des fréquences d'oscillateurs constitués chacun d'un balancier d'inertie prédéterminé et d'un des spiraux horlogers de test accouplé à cet oscillateur d'inertie prédéterminé. De préférence, le spiral horloger de test a été détaché de la plaquette de test avant d'être accouplé au balancier d'inertie prédéterminé et avant que soit effectuée la mesure de fréquence. La mesure de fréquence peut également être réalisée alors que le spiral horloger de test est toujours attaché à la plaquette de test. Dans ce cas, la mesure de fréquence peut être réalisée selon les enseignements du document EP 2 423 764.

Toujours dans l'opération 528, on détermine les degrés de correction à partir des mesures pour correction effectuées sur les spiraux horlogers de test réalisés dans la même plaquette de test.

Pour ce faire, on utilise la relation qui établit le couple élastique d'un spiral en fonction notamment de ses dimensions et qui est la suivante :

$$M = \frac{E.h.l^3}{12.L} \qquad (1)$$

où :

- M est le couple élastique du spiral,
- E est le module d'élasticité du brin élastiquement flexible du spiral horloger,
- h est la hauteur du brin élastiquement flexible du spiral horloger,
- *l* est l'épaisseur du brin élastiquement flexible du spiral horloger, et
- L est la longueur du brin élastiquement flexible du spiral horloger.

Sur la figure 8, un plan de plaquette 35 indique la position de cellules 36, dont chacune est une région où découper un seul spiral horloger.

A chaque cellule 36, on attribue le degré de correction déduit de la mesure pour correction effectuée sur le spiral horloger de test découpé au niveau de cette cellule 36.

Par exemple, pour déterminer les degrés de correction à partir des mesures pour correction effectuées sur les spiraux horlogers de test réalisés dans la même plaquette de test, on peut procéder comme suit.

La relation (1) dans un cas spécifique permet de choisir $h_6$, $L_6$ et $l_6$ pour obtenir la valeur $M_6$ visée, du fait que :

$$M_6 = \frac{E.h_6.l_6^3}{12.L_6}$$

où :

- $M_6$ est le couple élastique visé,
- E est le module d'élasticité du brin élastiquement flexible du spiral horloger,
- $h_6$ est la hauteur visée du brin élastiquement flexible du spiral horloger,
- $l_6$ est l'épaisseur visée du brin élastiquement flexible du spiral horloger, et
- Le est la longueur visée du brin élastiquement flexible du spiral horloger.

La forme d'un spiral horloger est tel que l'erreur (due à la gravure DRIE) qui affecte beaucoup plus le module élastique M que les autres erreurs est l'erreur sur la largeur *l* du spiral horloger. On peut donc négliger l'erreur sur la hauteur h du spiral, ainsi que l'erreur sur la longueur L du spiral.

A partir d'un module élastique $M_7$ obtenu par mesure sur un spiral horloger de test dans une cellule 36, on détermine la correction $\Delta l$ à appliquer dans cette cellule 36 en résolvant l'équation suivante :

$$M_7 = \frac{E.h_6.(l_6 + \Delta\, l)^3}{12.L_6}$$

Dans le cas ou $M_7$ mesuré est supérieur à $M_6$ visé, la largeur de la fenêtre 12 au niveau du brin élastiquement flexible 3 correspondant, devant avoir sensiblement la largeur $l_6$, sera réduite de la grandeur $\Delta l$.

Dans le cas ou $M_7$ mesuré est inférieur à $M_6$ visé, la largeur de la fenêtre 12 au niveau du brin élastiquement flexible 3 correspondant, devant avoir sensiblement la largeur $l_6$, sera augmentée de la grandeur $\Delta l$.

Dans le cas ou $M_7$ mesuré est égal ou sensiblement égal à $M_6$ visé, la largeur de la fenêtre 12 au niveau du brin élastiquement flexible 3 correspondant, devant avoir sensiblement la largeur $l_6$, ne sera pas corrigée, c'est-à-dire qu'elle ne sera pas modifiée.

A chaque cellule 36, on peut associer un degré de correction individuel.

On peut également associer un degré de correction identique moyen à une famille de cellules 36 au niveau desquelles les degrés de correction individuels obtenus sont voisins, par exemple compris dans un intervalle prédéfini pouvant par exemple correspondre à une classe de spiraux horlogers. Tel est le cas dans le procédé de fabrication 11. Sur la figure 8, un même degré de correction est appliqué au niveau des cellules désignées par la lettre A. Un même degré de correction est appliqué au niveau des cellules désignées par la lettre B. Un même degré de correction est appliqué au niveau des cellules désignées par la lettre C. Un même degré de correction est appliqué au niveau des cellules désignées par la lettre D.

Le degré de correction appliqué au niveau des cellules A est supérieur au degré de correction appliqué au niveau des cellules B. Le degré de correction appliqué au niveau des cellules B est supérieur au degré de correction appliqué au niveau des cellules C. Le degré de correction appliqué au niveau des cellules C est supérieur au degré de correction appliqué au niveau des cellules D.

Sur la figure 8, le degré de correction augmente globalement de l'intérieur vers l'extérieur (les cellules A sont plutôt en périphérie tandis que les cellules C sont plutôt au centre du plan de plaquette 35). Toutefois, la figure 8 est seulement un exemple et n'est aucunement limitative. En effet, la répartition des degrés de correction sur le plan de plaquette 35 peut être n'importe laquelle. En d'autres termes, la répartition des degrés de correction sur le plan de plaquette 35 peut être très différente de celle représentée sur la figure 8 comme en être très semblable.

Chaque degré de correction est une modification d'au moins une dimension de la fenêtre 12 du masque réutilisable corrigé 11, par rapport à une fenêtre du masque réutilisable non corrigé employé dans l'opération 522. En particulier, un degré de correction peut se traduire par une augmentation ou une diminution de la largeur de la partie du masque réutilisable corrigé 11 correspondant à un brin élastiquement flexible 3 d'un spiral horloger 1. La modification de largeur peut être constante sur toute la longueur de la partie correspondante à un brin élastiquement flexible 3. L'augmentation de largeur ou la diminution de largeur peut également ne pas être constante sur toute la longueur de la partie correspondante à un brin élastiquement flexible 3.

Les opérations 522, 524, 526 et 528 peuvent être réitérées plusieurs fois de manière que l'on dispose de plusieurs degrés de correction obtenus expérimentalement pour chaque cellule 36 et que l'on puisse calculer un degré de correction moyen pour chaque cellule 36 et déterminer une cartographie 30 sur la base des moyennes de degrés de correction obtenues chacune pour une cellule 36 du plan de plaquette 35.

Dans le procédé de fabrication 10, on découpe des spiraux horlogers test dans la plaquette de test, lors de l'étape 526. Toutefois, lors de l'étape 526, on peut découper dans la plaquette de test des structures de test qui ne soient pas des spiraux horlogers. Ces structures de test peuvent être configurées pour permettre une mesure du module d'élasticité M et pour que la variation des modules d'élasticité entre deux plaquettes 22 soit proportionnelle à la correction à effectuer sur les spiraux horlogers 1. Les structures de test découpées lors de l'opération 526 dans la plaquette de test peuvent être également des figures géométriques, auquel cas les mesures pour correction effectuées lors de l'opération 528 peuvent être des mesures dimensionnelles sur ces figures géométriques.

L'étape préparatoire 500 comprend une sous-étape 540 qui succède à l'étape 520. Dans la sous-étape 540, on réalise le masque réutilisable corrigé 11 de telle manière que les fenêtres 12 de ce masque réutilisable corrigé 11 soient dimensionnées en fonction de la cartographie 30 réalisée à la sous-étape 520.

Dans le procédé de fabrication 10 selon un premier mode de réalisation de la deuxième invention, la correction intégrée dans le masque réutilisable corrigé 11 constitue une première correction, laquelle vise à réduire la dispersion des couples élastiques de spiraux horlogers 1 réalisés ensemble et en même temps par gravure dans une même plaquette 22, dans une installation de gravure.

Le procédé de fabrication 10 selon un premier mode de réalisation de la deuxième invention inclut une deuxième correction, laquelle vise à réduire l'hétérogénéité entre deux gravures effectuées dans une même installation de gravure, au moyen du même masque réutilisable corrigé 11, mais à deux moments différents et chacune sur une plaquette 22 différente. En d'autres termes, la deuxième correction vise à réduire la dispersion entre les couples élastiques d'un premier jeu de spiraux horlogers 1 et d'un deuxième jeu de spiraux horlogers 1, les spiraux horlogers 1 du premier jeu ayant été gravés dans une première plaquette, tandis que les spiraux horlogers 1 du deuxième jeu ont été gravés dans une deuxième plaquette, avant ou après les spiraux horlogers 1 du premier jeu.

Du fait qu'il inclut la deuxième correction, le procédé de fabrication 10 est un procédé de fabrication d'un lot de spiraux horlogers 1 dont les couples élastiques ont une moyenne dans une plage prédéterminée. Afin de pouvoir réaliser la deuxième correction, on réalise le masque réutilisable corrigé 11 de telle manière que, en plus d'être dimensionné en fonction de la cartographie 30 réalisée à la sous-étape 520, les fenêtres 12 soient dimensionnées pour qu'à l'étape 102, les spiraux horlogers 1 soient découpés par gravure selon des dimensions supérieures aux dimensions nécessaires pour l'obtention du lot de spiraux horlogers 1 dont les couples élastiques ont la moyenne dans la plage prédéterminée.

En outre, toujours pour réaliser la deuxième correction, le procédé de fabrication 10 comprend deux étapes qui suivent l'étape 102 et qui sont une étape 110 et une étape 120 succédant à cette étape 110.

Dans l'étape 110, on détermine une quantité de matière à retirer des spiraux horlogers 1 réalisés à l'étape 102 dans la même plaquette 22. Cette quantité de matière à retirer est plus précisément celle que l'on doit retirer de ces spiraux horlogers 1, après l'étape 102, pour obtenir le lot de spiraux horlogers 1 ayant les couples élastiques dont la moyenne est dans la plage prédéterminée.

Dans le cas du procédé de fabrication 10 selon un premier mode de réalisation de la deuxième invention, cette quantité de matière à retirer est une épaisseur de matière à retirer sur les spiraux horlogers 1 réalisés à l'étape 102.

Pour effectuer l'étape 110, on procède de préférence comme suit. On commence par détacher de la plaquette 22 plusieurs spiraux horlogers 1 constituant un échantillon sacrificiel. Cet échantillon sacrificiel est qualifié de « sacrificiel » car les spiraux horlogers 1 le constituant vont servir à effectuer des mesures, après quoi, dans un souci d'efficacité et de rentabilité, ils peuvent ne pas être conservés parmi les spiraux horlogers 1 auxquels est appliquée l'étape 120. Les spiraux horlogers de l'échantillon sacrificiel peuvent être au nombre de 5 à 15 et sont avantageusement choisis en des emplacements répartis sur l'ensemble du plan de plaquette 35.

Une fois dissocié de la plaquette 22, chacun des spiraux horlogers 1 de l'échantillon sacrificiel est accouplé à un balancier d'inertie prédéterminé afin de constituer avec celui-ci un oscillateur mécanique dont on mesure la fréquence $f$, toujours dans l'étape 110. Après cela, on dispose d'autant de mesures de fréquence $f$ qu'il y a de spiraux horlogers 1 dans l'échantillon sacrificiel. On calcule alors la moyenne $\overline{f}$ de ces fréquences $f$ mesurées sur les oscillateurs mécaniques comprenant les spiraux horlogers 1 de l'échantillon sacrificiel.

Le couple élastique moyen des spiraux horlogers de l'échantillon sacrificiel peut être déterminé à partir des fréquences $f$ mesurées et/ou à partir de la moyenne $\overline{f}$ de ces fréquences f mesurées, au moyen de la relation suivante :

$$f = \frac{1}{2\pi}\sqrt{M/I} \qquad (2)$$

où :

- f est la fréquence (propre) du balancier-spiral,
- I est le moment d'inertie du balancier autour de son axe de rotation, et
- M est le couple élastique du spiral horloger.

Ensuite, pour déterminer l'épaisseur de matière à retirer, on utilise une table de correspondance donnant une épaisseur de matière à retirer pour chacun de plusieurs couples élastiques moyens.

La table de correspondance susmentionnée a été obtenue expérimentalement. Pour établir cette table de correspondance susmentionnée, on peut procéder de la manière suivante : d'abord, on détermine expérimentalement de combien un retrait d'une épaisseur d'un micron sur toute la surface d'un spiral horloger réduit la classe attribuable à ce spiral horloger 1. Ensuite, en utilisant une règle de trois, c'est-à-dire par proportionnalité, on calcule le nombre de microns d'épaisseur à enlever pour chacun de plusieurs couples élastiques moyens.

En variante, on peut utiliser une table de correspondance indiquant l'épaisseur de matière à retirer pour chacune de plusieurs fréquences moyennes $\overline{f}$.

Pour déterminer l'épaisseur de matière à retirer, on peut également utiliser un modèle mathématique au lieu de la table de correspondance.

Selon une autre variante de réalisation conforme à la deuxième invention, il est possible de déterminer l'épaisseur de matière à retirer sur les spiraux horlogers 1 par calcul à partir des fréquences $f$ mesurées et/ou à partir de la moyenne $\overline{f}$, en utilisant la formule (1) explicitée plus haut.

De plus, selon une variante de réalisation, la mesure de fréquence peut être effectué sur des spiraux horlogers 1 qui n'ont pas été détachés de la plaquette 22. Dans ce cas, la mesure de fréquence peut être effectuée selon les enseignements du document EP 2 423 764.

De plus, l'épaisseur de matière à retirer des spiraux horlogers 1 réalisés à l'étape 102 peut être déterminée à partir d'une mesure d'une grandeur autre que la fréquence d'un oscillateur constitué d'un spiral horloger 1 et d'un balancier d'inertie prédéterminée.

Par exemple, l'épaisseur de matière à retirer des spiraux horlogers 1 réalisés à l'étape 102 peut être déterminée à partir de mesures dimensionnelles de portions découpées par gravure dans la plaquette 22, ces portions découpées par gravure par la plaquette 22 pouvant être des portions des spiraux horlogers 1 ou bien des figures géométriques découpées dans la plaquette en plus des spiraux horlogers 1. La quantité de matière à retirer des spiraux horlogers 1 réalisés à l'étape 102 peut également être déterminée à partir d'une mesure de raideur effectuée sur des structures de qualification qui ont été découpées dans la plaquette 22 en même temps que les spiraux horlogers 1.

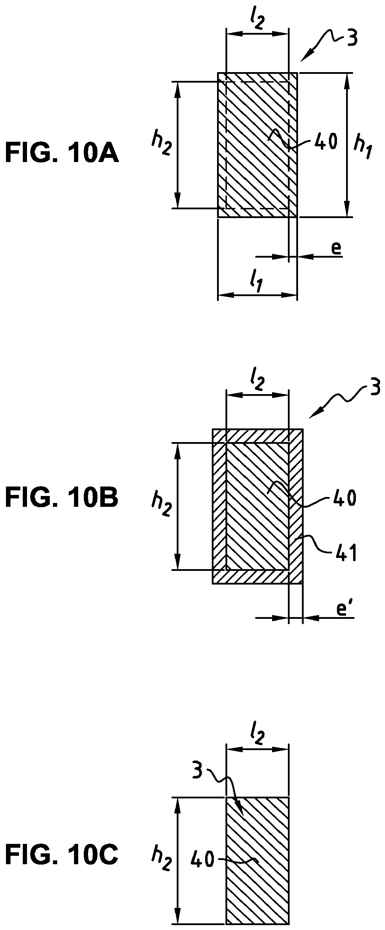

Sur la figure 10A est représentée la section transversale d'un brin élastiquement flexible 3 d'un spiral horloger 1 qui vient d'être découpé par gravure dans l'étape 102 mais qui n'a pas encore subi l'oxydation.

Quelle que soit la méthode utilisée pour la détermination de l'épaisseur de matière à retirer e des spiraux horlogers 1 à l'issue de l'étape 102, il peut avantageusement être tenu compte pour cette détermination de ce que la hauteur $h_1$ du brin élastiquement flexible 3 d'un spiral horloger 1 à l'issue de l'étape 102 est connue avec une précision assez élevée puisqu'elle est égale à l'épaisseur de la plaquette 22. De la sorte, l'inexactitude d'un spiral horloger 1 à l'issue de l'étape 102 peut être considérée comme étant principalement due aux étapes 100, 101 et 102, et concerner surtout la largeur $l_1$ du brin élastiquement flexible 3 de ce spiral horloger 1.

Dans l'étape 120 dans le cas du procédé de fabrication 10 selon un premier mode de réalisation de la deuxième invention, l'épaisseur de matière à retirer e déterminée à l'étape 110 est retirée sur les spiraux horlogers 1 encore attachés à la plaquette 22 et, dans un souci d'économie, elle peut ne pas être retirée des spiraux horlogers 1 appartenant à l'échantillon sacrificiel.

L'étape 120 peut être réalisée en suivant les enseignements du document WO 2015/113973 A1. Plus précisément, dans le cas du procédé de fabrication 10 selon un premier mode de réalisation de la deuxième invention, les spiraux horlogers 1 encore attachés à la plaquette 22 sont soumis collectivement, en même temps, à l'étape 120. Dans l'étape 120 dans le cas du procédé de fabrication 10 selon un premier mode de réalisation de la deuxième invention, l'épaisseur de matière à retirer e déterminée à l'étape 110 est retirée sur toute la surface du brin élastiquement flexible 3 de chacun des spiraux horlogers 1 réalisés à l'étape 102 et restés attachés à la plaquette 22.

Dans le cas du procédé de fabrication 10 selon un premier mode de réalisation de la deuxième invention, l'étape 120 comprend une sous-étape 122 et une sous-étape 124 succédant à l'étape 122. Pour mémoire, dans le cas du procédé de fabrication 10 selon un premier mode de réalisation de la deuxième invention, les spiraux horlogers 1 après l'étape 102 sont faits de silicium, qui est le silicium de la plaquette 22.

Dans la sous-étape 122, au moins une partie des spiraux horlogers 1 réalisés dans la plaquette 22 à l'étape 102 sont soumis à une oxydation telle que l'épaisseur de silicium transformé en oxyde de silicium soit égale à l'épaisseur de matière à retirer e déterminée à l'étape 110. L'oxydation peut être notamment une oxydation thermique réalisé entre 800 °C et 1200°C sous atmosphère oxydante, dans un four où du dioxyde silicium se forme à partir du silicium. L'oxydation thermique peut être une oxydation humide obtenue en présence de vapeur d'eau dans le four ou bien une oxydation sèche obtenue en présence de dioxygène dans le four. Le temps d'oxydation peut être déterminé par des formules appropriées bien connues de l'homme du métier ou il peut être déterminé à partir de calculateurs disponibles en ligne, par exemple à l'adresse suivant : http://lelandstanfordjunior.com/thermaloxide.html. L'épaisseur d'oxyde de silicium (dioxyde de silicium) formé varie légèrement selon l'orientation cristallographique du silicium, mais les différences sont négligeables. L'épaisseur de matière à retirer e correspond typiquement à environ à 44% de l'épaisseur (référencée e' sur la figure 10B mentionnée plus loin) d'oxyde de silicium formé.

Dans le procédé de fabrication 10, les spiraux horlogers 1 restés attachés à la plaquette 22 sont soumis ensemble et collectivement à l'oxydation, alors qu'ils sont toujours attachés à la plaquette 22. Les spiraux horlogers 1 de l'échantillon sacrificiel peuvent ne pas être soumis à l'étape 120 et aux étapes suivantes, dans un souci d'efficacité et de rentabilité. Dans la variante où aucun des spiraux horlogers 1 n'a été détaché de la plaquette 22, l'ensemble des spiraux horlogers 1 réalisés à l'étape 102 dans la plaquette 22 sont soumis ensemble et collectivement à l'oxydation alors qu'ils sont toujours attachés à la plaquette 22.

Le brin élastiquement flexible 3 représenté sur la figure 10B est le même que celui représenté sur la figure 10A. Sur cette figure 10B, ce brin élastiquement flexible 3 est oxydé superficiellement, après avoir subi la sous-étape 122. Sur la figure 10B, la référence 40 désigne le silicium non oxydé et la référence 41 désigne le dioxyde de silicium qui s'est formé pendant la sous-étape 122. L'épaisseur e' de la couche faite du dioxyde de silicium 41 résultant de l'oxydation à la sous-étape 122 est supérieure à l'épaisseur e du silicium non oxydé 40 dont l'oxydation a conduit à ce dioxyde de silicium 41.

Dans la sous-étape 124, on retire le dioxyde de silicium 41 d'au moins une partie des spiraux horlogers 1 découpés dans la plaquette 22 lors de l'étape 102. Le dioxyde de silicium peut être retiré par gravage, ou par attaque chimique, par exemple avec de l'acide fluorhydrique.

Dans le procédé de fabrication 10, les spiraux horlogers 1 restés attachés à la plaquette 22 sont soumis ensemble et collectivement à la sous-étape 124. Dans le cas où aucun des spiraux horlogers 1 réalisés dans la plaquette 22 n'est détaché de cette plaquette 22 dans l'étape 110, l'ensemble des spiraux horlogers 1 découpés par gravure dans l'étape 102 sont soumis ensemble et collectivement à la sous-étape 124.

La figure 10C représente le même brin élastiquement flexible 3 que les figures 10A et 10B. Sur la figure 10C, ce brin élastiquement flexible 3 est débarrassé du dioxyde de silicium 41, après avoir subi la sous-étape 124. Le brin élastiquement flexible 3 de la figure 10C a une hauteur $h_2$ inférieure à la hauteur $h_1$ et une largeur $l_2$ inférieure à la largeur $l_1$.

L'étape 120 peut comprendre les sous-étapes 122 et 124 également lorsque la plaquette 22 n'est pas faite de silicium. En particulier, l'étape 120 peut comprendre les sous-étapes 122 et 124 lorsque la plaquette 22 est faite d'un matériau à base de silicium.

L'étape 120 peut être réalisée d'une manière autre que celle décrite ci-dessus. La diminution de section du brin élastiquement flexible 3 des spiraux horlogers 1 peut être réalisée au moyen d'un plasma, et ce soit alors que les spiraux horlogers 1 sont dans l'état de la figure 6, c'est-à-dire pas encore libérés du support 20 et de la couche d'arrêt 21, soit alors que les spiraux horlogers 1 ou une partie des spiraux horlogers 1 sont dans l'état représenté sur la figure 7, c'est-à-dire libérés de la couche d'arrêt 21 et du support 20, mais encore attachés à la plaquette 22. La réduction de section au moyen d'un plasma peut être effectuée y compris lorsque le masque sacrificiel 18 est encore présent sur une face des spiraux horlogers 1, auquel cas seuls les flancs latéraux des spiraux horlogers 1 sont entamés.

Des variantes à l'étape 120 sont possibles. On peut, par exemple oxyder le spiral avec une épaisseur d'oxyde w avant l'étape 110. Cette épaisseur d'oxyde w correspond à l'épaisseur finale de thermocompensation ou à une épaisseur choisie. Le spiral est mesuré après oxydation. On diminue le couple élastique en désoxydant partiellement ou totalement le spiral et en le reoxydant à la valeur w.

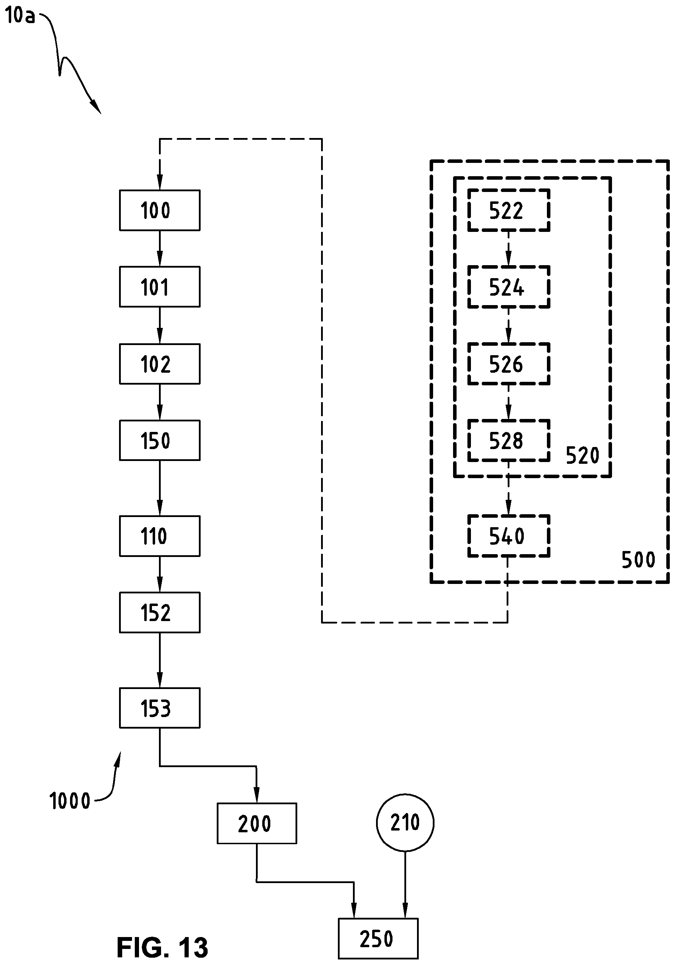

A cet égard, la figure 13 représente les étapes successives d'un procédé de fabrication 10a selon un deuxième mode de réalisation de la deuxième invention. Le procédé de fabrication 10a est un procédé de fabrication d'un lot de spiraux horlogers 1. Le procédé de fabrication 10a comprend un procédé de fabrication 1000 selon un mode de réalisation de la première invention susmentionnée. Dans l'exemple représenté à la figure 13, le procédé de fabrication 1000 fait partie du procédé de fabrication 10a. Toutefois, il peut en être autrement. En d'autres termes, le procédé de fabrication 1000 peut être mis en oeuvre sans que soit mis en oeuvre tout ou partie des autres étapes du procédé de fabrication 10a.

Le procédé de fabrication 1000 est un procédé de fabrication d'un lot de spiraux horlogers (1) dont les couples élastiques ont une moyenne dans une plage prédéterminée. Le procédé de fabrication 1000 comprend des étapes 150, 152 et 153, en plus des étapes 102 et 110 déjà décrites plus haut.

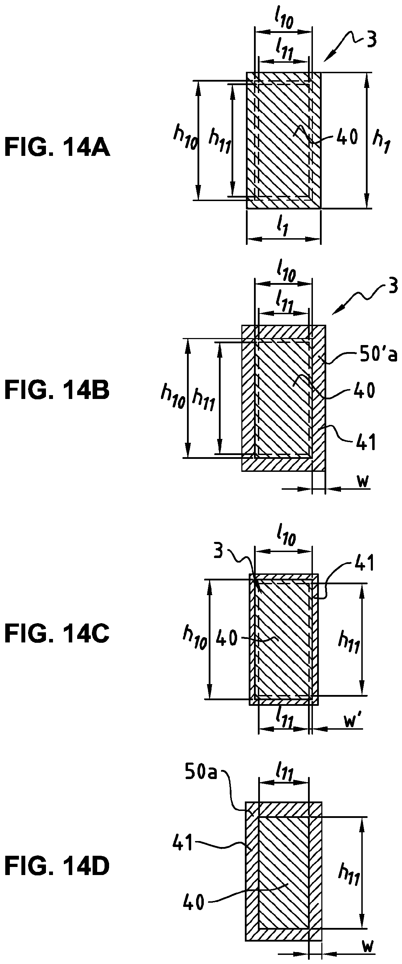

L'étape 150 suit l'étape 102, à l'issue de laquelle le brin élastiquement flexible 3 de chacun des spiraux horlogers 1 découpés dans la plaquette 22 est tel que représenté sur la figure 14A.

A l'issue de l'étape 150, le brin élastiquement flexible 3 de chacun des spiraux horlogers 1 découpés dans la plaquette 22 est tel que représenté sur la figure 14B. Dans l'étape 150, plusieurs ou la totalité des spiraux horlogers 1 sont soumis à une première oxydation de manière être transformés en spiraux horlogers oxydés superficiellement chacun dans une zone où, à partir du matériau à base de silicium, la première oxydation crée une portion de compensation thermique 50'a prévue pour modifier la sensibilité aux variations de température du couple élastique du spiral horloger 1 correspondant. Sur la figure 14B, la référence w désigne l'épaisseur de la portion de compensation thermique 50'a.

L'étape 150 est suivie de l'étape 110, dans laquelle, à partir d'au moins une mesure sur au moins une partie des spiraux horlogers 1 oxydés, on détermine la quantité de matériau à base de silicium (référencée w' sur la figure 14C) à retirer des spiraux horlogers 1 oxydés, pour obtenir le lot de spiraux horlogers 1 ayant les couples élastiques dont la moyenne est dans la plage prédéterminée. Des exemples de mesures pouvant être employée dans l'étape 110 ont été décrites plus haut.

L'étape 152 suit l'étape 110. Le brin élastiquement flexible 3 de chacun des spiraux horlogers 1 découpés dans la plaquette 22 est tel que représenté sur la figure 14C à l'issue de l'étape 152, dans laquelle, de la portion de compensation thermique 50'a de plusieurs ou de la totalité des spiraux horlogers 1, on retire une épaisseur résiduaire qui correspond à la quantité de matériau à base de silicium à retirer w'. Dans l'étape 152, l'épaisseur résiduaire retirée de la portion de compensation thermique 50'a correspond à la quantité de matériau à base de silicium à retirer w' et elle peut ne pas être égale à l'épaisseur de cette quantité de matériau à base de silicium à retirer w'.

En effet, l'épaisseur résiduaire retirée dans l'étape 152 est faite du matériau à base de silicium oxydé, qui constitue la portion de compensation thermique 50'a et qui peut être du dioxyde de silicium 41 dans le cas où le matériau à base de silicium est du silicium. En d'autres termes, l'épaisseur résiduaire retirée de la portion de compensation thermique 50'a dans l'étape 152 n'est pas faite du même matériau que la quantité de matériau à base de silicium à retirer w'. L'épaisseur résiduaire retirée de la portion de compensation thermique dans l'étape 152 est faite du matériau résultant de l'oxydation du matériau à base de silicium à retirer w'.

Dans le cas où le matériau à base de silicium à retirer est du silicium 40 (dopé ou non dopé), l'épaisseur résiduaire retirée de la portion de compensation thermique 50'a dans l'étape 152 est faite de dioxyde de silicium 41. Dans le cas où le matériau à base de silicium à retirer est du silicium 40 (dopé ou non dopé), l'épaisseur résiduaire retirée de la portion de compensation thermique 50'a dans l'étape 152 est égale à environ 227% de l'épaisseur de la quantité de matériau à base de silicium à retirer w'.

L'épaisseur résiduaire retirée dans l'étape 152 résiduaire est telle que la quantité du matériau à base de silicium consommée lors d'une deuxième oxydation régénérant la portion de compensation thermique à l'étape 153 soit égale à la quantité de matériau à base de silicium à retirer dans l'étape 152.

Dans le cas où la portion de compensation thermique 50'a est faite de dioxyde de silicium 41, l'épaisseur résiduaire qui correspond à la quantité de matériau à base de silicium à retirer w' peut être retirée de la portion de compensation thermique 50'a au moyen d'une attaque chimique, par exemple en employant de l'acide chlorhydrique. La durée de cette attaque chimique est une durée contrôlée, préalablement déterminée en fonction de la quantité de matériau à base de silicium à retirer w'.

L'étape 153 suit l'étape 152. Le brin élastiquement flexible 3 de chacun des spiraux horlogers 1 découpés dans la plaquette 22 est tel que représenté sur la figure 14D à l'issue de l'étape 153, dans laquelle plusieurs ou la totalité des spiraux horlogers 1 oxydés sont soumis à une deuxième oxydation telle que la portion de compensation thermique soit régénérée. Sur la figure 14D, la référence w désigne l'épaisseur de la portion de compensation thermique 50a telle qu'elle est après avoir été régénérée.

Sur les figures, 14A, 14B, 14C et 14D, la référence 40 désigne le matériau à base de silicium, qui peut notamment être du silicium dopé ou non dopé, ce qui est le cas dans le procédé de fabrication 1000 selon un mode de réalisation de la première invention. Sur les figures, 14A, 14B, 14C et 14D, la référence 41 désigne le matériau à base de silicium oxydé, qui peut notamment être du dioxyde de silicium, ce qui est le cas dans le procédé de fabrication 1000 selon un mode de réalisation de la première invention.

Le procédé de fabrication 10a selon un deuxième mode de réalisation de la deuxième invention se distingue du procédé 10 en ce qu'il comporte la succession des étapes 150, 110, 152 et 153, au lieu de la succession des étapes 110, 120 et 130. Pour le reste, le procédé de fabrication 10a peut être identique au procédé de fabrication 10, ce qui est le cas dans le deuxième mode de réalisation de la deuxième invention.

Dans le cas où on détermine à l'étape 110 qu'il n'y a pas de matériau à base de silicium à retirer, on ne réalise pas les étapes 152 et 153.

De préférence, l'étape 150 est réalisée collectivement sur les spiraux horlogers 1 encore attachés à la plaquette 22.

De préférence, l'étape 152 est réalisée collectivement sur les spiraux horlogers 1 encore attachés à la plaquette 22.

De préférence, l'étape 153 est réalisée collectivement sur les spiraux horlogers 1 encore attachés à la plaquette 22.

De préférence, la quantité de matériau à base de silicium à retirer w' est déterminée à partir d'une mesure effectuée sur un échantillon sacrificiel prélevé parmi les spiraux horlogers 1 de la plaquette 22 et qui est dissocié de la plaquette 22.

De préférence, dans l'étape 110, la quantité de matériau à base de silicium à retirer w' est déterminée au moyen d'une table de correspondance indiquant l'épaisseur de matériau à base de silicium à retirer w' pour chacun de plusieurs couples élastiques moyens ou pour chacune de plusieurs grandeurs liées à de tels couples élastiques moyens.

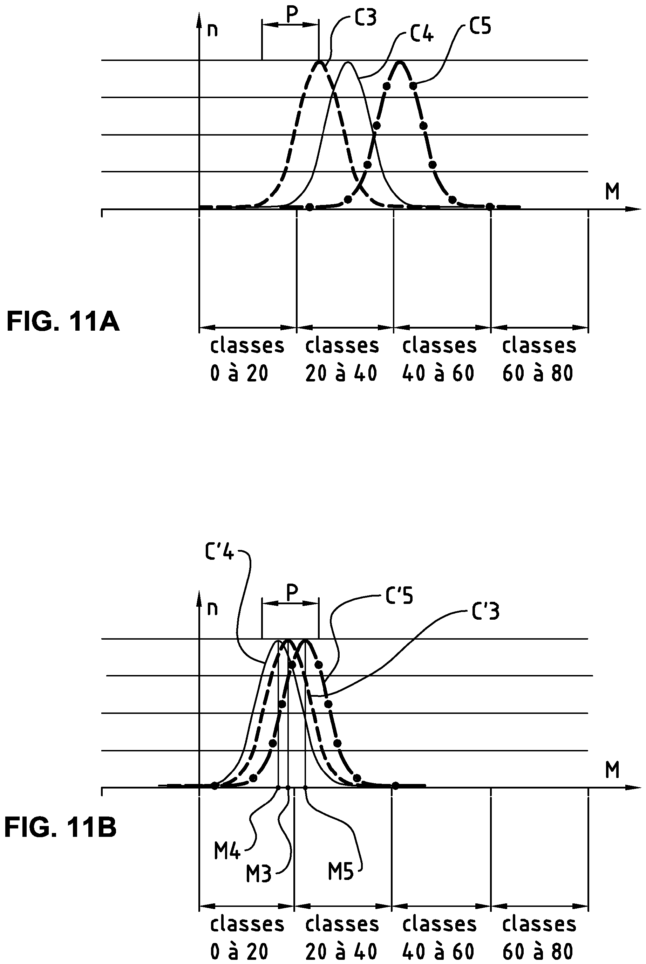

Sur le graphe de la figure 11A et sur le graphe de la figure 11B, le couple élastique M est en abscisse, tandis que le nombre n de spiraux horlogers 1 parmi tous les spiraux horlogers 1 réalisés dans une même plaquette 22 à l'étape 102 lors d'une mise en oeuvre du procédé de fabrication 10 sont en ordonnées.

Sur le graphe de la figure 11A, les courbes C3, C4 et C5 sont normalement des histogrammes mais elles ont été lissées dans un souci de clarté. Sur le graphe de la figure 11B, les courbes C'3, C'4 et C'5 sont normalement des histogrammes mais elles ont été lissées dans un souci de clarté.

Sur les graphes des figures 11A et 11B, des classes croissantes de couple élastique sont également indiquées le long de l'axe des abscisses. Dans l'exemple représenté sur les figures 11A et 11B, le nombre de classes est égal à 80, mais il pourrait être autre moyennant une autre segmentation en classes. Par exemple, le nombre de classes pourrait être égal à 20 comme c'était l'usage autrefois.

La courbe C3 sur la figure 11A et la courbe C'3 sur la figure 11B sont chacune une représentation graphique de la dispersion des couples élastiques de spiraux horlogers 1 réalisés dans une même première plaquette 22, lors d'une première mise en oeuvre du procédé de fabrication 10 ou 10a dans laquelle est utilisé le masque réutilisable corrigé 11. Les mesures employées pour la courbe C3 ont été réalisées sur les spiraux horlogers 1 avant que ces spiraux horlogers 1 aient été soumis aux étapes 110 et 120, ou aux étapes 110, 152 et 153. Les mesures employées pour la courbe C'3 ont été réalisées sur les spiraux horlogers 1 après que ces spiraux horlogers 1 ont été soumis aux étapes 110 et 120, ou aux étapes 110, 152 et 153.

La courbe C4 sur la figure 11A et la courbe C'4 sur la figure 11B sont chacune une représentation graphique de la dispersion des couples élastiques de spiraux horlogers 1 réalisés dans une même deuxième plaquette 22, lors d'une deuxième mise en oeuvre du procédé de fabrication 10 ou 10a dans laquelle est utilisé le même masque réutilisable corrigé 11 que dans la première mise en oeuvre du procédé de fabrication 10 ou 10a. Les mesures employées pour la courbe C4 ont été réalisées sur les spiraux horlogers 1 avant que ces spiraux horlogers 1 aient été soumis aux étapes 110 et 120, ou aux étapes 110, 152 et 153. Les mesures employées pour la courbe C'4 ont été réalisées sur les spiraux horlogers 1 après que ces spiraux horlogers 1 ont été soumis aux étapes 110 et 120, ou aux étapes 110, 152 et 153.

La courbe C5 sur la figure 11A et la courbe C'5 sur la figure 11B sont chacune une représentation graphique de la dispersion des couples élastiques de spiraux horlogers 1 réalisés dans une même troisième plaquette 22, lors d'une troisième mise en oeuvre du procédé de fabrication 10 ou 10a dans laquelle est utilisé le même masque réutilisable corrigé 11 que dans la première et la deuxième mise en oeuvre du procédé de fabrication 10 ou 10a. Les mesures employées pour la courbe C5 ont été réalisées sur les spiraux horlogers 1 avant que ces spiraux horlogers 1 aient été soumis aux étapes 110 et 120, ou aux étapes 110, 152 et 153. Les mesures employées pour la courbe C'5 ont été réalisées sur les spiraux horlogers 1 après que ces spiraux horlogers 1 ont été soumis aux étapes 110 et 120, ou aux étapes 110, 152 et 153.

Les mesures employées pour la courbe C3, la courbe C4 et la courbe C5 sur la figure 11A ont été réalisées sur des spiraux horlogers 1 ayant bénéficié de la première correction incorporée au masque réutilisable corrigé 11. Les mesures employées pour la courbe C'3, la courbe C'4 et la courbe C'5 sur la figure 11B ont été réalisées sur des spiraux horlogers 1 ayant bénéficié à la fois de la première correction incorporée au masque réutilisable corrigé 11 et de la deuxième correction résultant des étapes 110 et 120 ou des étapes 110, 152 et 153. Par conséquent, une comparaison des figures 11A et 11B permet d'appréhender aisément l'effet de la deuxième correction résultant des étapes 110 et 120, ou des étapes 110, 152 et 153.

Les spiraux horlogers 1 ayant été réalisés dans la première plaquette 22 et ayant été soumis aux étapes 110 et 120, ou aux étapes 110, 152 et 153, c'est-à-dire les spiraux horlogers 1 sur lesquels ont été effectuées les mesures employées pour réaliser la courbe C'3, constituent un premier lot de spiraux horlogers 1 dont les couples élastiques ont une moyenne (notée $M_3$ sur la figure 11B) dans une plage prédéterminée, qui est la plage prédéterminée P sur la figure 11B.

Les spiraux horlogers 1 ayant été réalisé dans la deuxième plaquette 22 et ayant été soumis aux étapes 110 et 120, ou aux étapes 110, 152 et 153, c'est-à-dire les spiraux horlogers 1 sur lesquels ont été effectuées les mesures employées pour réaliser la courbe C'4, constituent un deuxième lot de spiraux horlogers 1 dont les couples élastiques ont une moyenne (notée $M_4$ sur la figure 11B) dans la plage prédéterminée P. Comme on peut le voir sur la figure 11A, avant d'avoir été soumis aux étapes 110 et 120, ou aux étapes 110, 152 et 153, les spiraux horlogers 1 ayant été réalisé dans la deuxième plaquette 22, c'est-à-dire les spiraux horlogers 1 sur lesquels ont été effectuées les mesures employées pour réaliser la courbe C4, ne constituaient pas un lot de spiraux horlogers 1 dont les couples élastiques ont une moyenne dans la plage prédéterminée P.

Les spiraux horlogers 1 ayant été réalisé dans la troisième plaquette 22 et ayant été soumis aux étapes 110 et 120, ou aux étapes 110, 152 et 153, c'est-à-dire les spiraux horlogers 1 sur lesquels ont été effectuées les mesures employées pour réaliser la courbe C'5, constituent un troisième lot de spiraux horlogers 1 dont les couples élastiques ont une moyenne (notée $M_5$ sur la figure 11B) dans la plage prédéterminée P. Comme on peut le voir sur la figure 11A, avant d'avoir été soumis aux étapes 110 et 120, ou aux étapes 110, 152 et 153, les spiraux horlogers 1 ayant été réalisé dans la troisième plaquette 22, c'est-à-dire les spiraux horlogers 1 sur lesquels ont été effectuées les mesures employées pour réaliser la courbe C5, ne constituaient pas un lot de spiraux horlogers 1 dont les couples élastiques ont une moyenne dans la plage prédéterminée P.

Ainsi qu'on peut le constater sur la figure 11B, les spiraux horlogers 1 ayant été réalisés dans les première, deuxième et troisième plaquettes 22 et ayant été soumis aux étapes 110 et 120, ou aux étapes 110, 152 et 153, c'est-à-dire les spiraux horlogers 1 sur lesquels ont été effectuées les mesures employées pour réaliser les courbes C'3, C'4 et C'5, peuvent tous être classés chacun dans l'un des classes 0 à 40. Or, lorsqu'un spiral horloger est classé dans n'importe laquelle des classes 1 à 40, il peut être appairé avec un balancier appartenant à l'une des classes 1 à 40, qui constituent un nombre réduit de classes.

Les étapes 110 et 120 peuvent être réitérées une ou plusieurs fois, jusqu'à ce que la moyenne des couples élastiques des spiraux horlogers 1 réalisés dans la même plaquette 22 soit dans la plage prédéterminée.

Les étapes 110, 152 et 153 peuvent être réitérées une ou plusieurs fois, jusqu'à ce que la moyenne des couples élastiques des spiraux horlogers 1 réalisés dans la même plaquette 22 soit dans la plage prédéterminée.

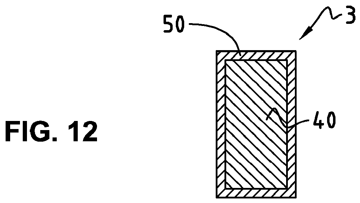

Ainsi qu'on peut le voir sur la figure 3, l'étape 120 peut être suivie d'une étape 130 dans laquelle, sur chacun de plusieurs spiraux horlogers 1 constituant au moins une partie des spiraux horlogers 1 réalisés dans la plaquette 22 à l'étape 102, on forme une portion de compensation thermique. Sur la figure 12, une telle portion de compensation thermique 50 présente la forme d'une couche périphérique recouvrant le brin élastiquement flexible 3 d'un spiral horloger 1.

La portion de compensation thermique 50 réduit, annule ou inverse la sensibilité aux variations de température du couple élastique du spiral horloger 1. Dans le cas où il n'y a pas les étapes 110 et 120, l'étape 130 peut être réalisée directement après l'étape 102.

Dans l'étape 130 dans le cas du procédé de fabrication 10 selon un premier mode de réalisation de la deuxième invention, la portion de compensation thermique 50 est formée sur les spiraux horlogers 1 encore attachés à la plaquette 22 et, dans un souci d'économie, elle peut ne pas être formées sur les spiraux horlogers 1 appartenant à l'échantillon sacrificiel. Dans le cas du procédé de fabrication 10 selon un premier mode de réalisation de la deuxième invention, les spiraux horlogers 1 encore attachés à la plaquette 22 sont soumis collectivement, ensemble et en même temps, à l'étape 130. Dans l'étape 130 dans le cas du procédé de fabrication 10 selon un premier mode de réalisation de la deuxième invention, la portion de compensation thermique est formée sur toute la longueur et toute la surface du brin élastiquement flexible 3 de chacun des spiraux horlogers 1 réalisés à l'étape 102 et restés attachés à la plaquette 22.

Pour mémoire, dans le cas du procédé de fabrication 10 selon un premier mode de réalisation de la deuxième invention, les spiraux horlogers 1 après l'étape 102 sont faits de silicium, qui est le silicium de la plaquette 22.

Dans l'étape 130, au moins une partie des spiraux horlogers 1 réalisés dans la plaquette 22 à l'étape 102 sont soumis à une oxydation de manière à être oxydés superficiellement sur une épaisseur qui est fonction du degré de compensation thermique souhaité. L'oxydation peut être notamment une oxydation thermique réalisée entre 800 °C et 1200°C sous atmosphère oxydante, dans un four où du dioxyde silicium se forme à partir du silicium. L'oxydation thermique de l'étape 130 peut être une oxydation humide obtenue en présence de vapeur d'eau dans le four ou bien une oxydation sèche obtenue en présence de dioxygène dans le four.

Dans le procédé de fabrication 10, les spiraux horlogers 1 restés attachés à la plaquette 22 sont soumis ensemble et collectivement à l'oxydation de l'étape 130, alors qu'ils sont toujours attachés à la plaquette 22. Les spiraux horlogers 1 de l'échantillon sacrificiel peuvent ne pas être soumis à l'étape 130, dans un souci d'efficacité et de rentabilité. Dans la variante où aucun des spiraux horlogers 1 n'a été détaché de la plaquette 22, l'ensemble des spiraux horlogers 1 réalisés à l'étape 102 dans la plaquette 22 sont soumis ensemble et collectivement à l'oxydation de l'étape 130 alors qu'ils sont toujours attachés à la plaquette 22.

Le coefficient thermique du module d'Young d'un matériau est encore appelé le coefficient thermoélastique de ce matériau. La figure 12 est une section transversale d'un brin élastiquement flexible 3 d'un spiral horloger 1 tel qu'il est après l'étape 130. Sur la figure 12, le brin élastiquement flexible 3 comporte une âme en silicium 40 et la portion de compensation thermique 50 qui enrobe cette âme en silicium 40. Le silicium 40 de l'âme possède un coefficient thermoélastique qui est négatif. Le dioxyde de silicium de la portion de compensation thermique 50 possède un coefficient thermoélastique qui est positif. C'est pourquoi la portion de compensation thermique 50 réduit ou annule ou même inverse la sensibilité aux variations de température du couple élastique du spiral horloger 1.

Après avoir été détachés de la plaquette 22, les spiraux horlogers 1 sont classés, par exemple chacun au moyen d'un appareil de type Omégamétric (marque commerciale protégée) dans une étape 200, qui suit l'étape 130, ou l'étape 120, ou bien encore l'étape 110. Après avoir été classés dans l'étape 200, les spiraux horlogers 1 provenant de la même plaquette 22 sont appairés à des balanciers 8, dans une étape 250. Dans cette étape 250, les spiraux horlogers 1 provenant de la même plaquette 22 sont appairés à des balanciers 8 choisis parmi ceux d'un lot que l'on s'est procuré dans une étape 210 et qui est constitué de balancier 8 classés.

## Revendications

1. Procédé de fabrication d'un lot de spiraux horlogers (1) dont les couples élastiques ont une moyenne ($M_3$, $M_4$, $M_5$) dans une plage prédéterminée (P), comprenant des étapes (102, 150, 110, 152, 153) dans lesquelles :

d) dans une plaquette en un matériau à base de silicium, on réalise les spiraux horlogers (1) selon des dimensions supérieures aux dimensions nécessaires pour l'obtention du lot de spiraux horlogers (1) dont les couples élastiques ont la moyenne ($M_3$, $M_4$, $M_5$) dans la plage prédéterminée (P),

w) plusieurs ou la totalité des spiraux horlogers (1) sont soumis à une première oxydation de manière être transformés en spiraux horlogers oxydés superficiellement chacun dans une zone où, à partir du matériau à base de silicium, la première oxydation crée une portion de compensation thermique (50'a) pour modifier la sensibilité aux variations de température du couple élastique du spiral horloger (1) correspondant, puis

e) à partir d'au moins une mesure sur au moins une partie des spiraux horlogers (1) oxydés, on détermine la quantité de matériau à base de silicium (w') à retirer des spiraux horlogers (1) oxydés, pour obtenir le lot de spiraux horlogers (1) ayant les couples élastiques dont la moyenne ($M_3$, $M_4$, $M_5$) est dans la plage prédéterminée (P),

x) de la portion de compensation thermique (50'a) de plusieurs ou de la totalité des spiraux horlogers (1), on retire une épaisseur résiduaire qui correspond à la quantité de matériau à base de silicium à retirer (w'), puis

y) plusieurs ou la totalité des spiraux horlogers (1) oxydés sont soumis à une deuxième oxydation telle que la portion de compensation thermique (50a) soit régénérée.

2. Procédé de fabrication selon la revendication 1, **caractérisé en ce que** dans l'étape d), on réalise les spiraux horlogers (1) par gravure, de préférence par gravure ionique réactive profonde.

3. Procédé de fabrication selon la revendication 1 ou 2, **caractérisé en ce qu'**au moins l'une parmi les étapes w), x), y) est réalisée collectivement sur les spiraux horlogers (1) encore attachés à la plaquette (22).

4. Procédé de fabrication selon l'une quelconque des revendications 1 à 3, **caractérisé en ce que**, dans l'étape e), la quantité de matériau à base de silicium à retirer (w') est déterminée à partir d'une mesure effectuée sur un échantillon sacrificiel prélevé parmi les spiraux horlogers (1) de la plaquette (22) et qui est dissocié de la plaquette (22).

5. Procédé de fabrication selon l'une quelconque des revendications 1 à 4, **caractérisé en ce que**, dans l'étape e), la quantité de matériau à base de silicium à retirer (w') est déterminée au moyen d'une table de correspondance indiquant l'épaisseur de matériau à base de silicium à retirer (w') pour chacun de plusieurs couples élastiques moyens ou pour chacune de plusieurs grandeurs liées à de tels couples élastiques moyens.

6. Procédé de fabrication selon l'une quelconque des revendications 1 à 5, **caractérisé en ce que** la quantité de matériau à base de silicium à retirer est une épaisseur de matériau à base de silicium à retirer (w') sur les spiraux horlogers (1) réalisés à l'étape d).

7. Procédé de fabrication selon l'une quelconque des revendications 1 à 6, **caractérisé en ce que** le matériau à base de silicium est du silicium, par exemple du silicium dopé.

8. Procédé de fabrication selon l'une quelconque des revendications 1 à 7, **caractérisé en ce qu'**il comprend une étape (100) dans laquelle :

b) entre au moins une source émettant un rayonnement (R) et une résine photosensible (16) portée par une face de la plaquette (22), un masque réutilisable (11) stoppe au moins une partie du rayonnement (R) sauf au niveau de zones comprenant plusieurs fenêtres (12) qui définissent les contours des spiraux horlogers (1) et que comporte ce masque réutilisable,

**en ce que** le masque réutilisable (11) est un masque réutilisable corrigé **en ce qu'**au moins une partie des fenêtres (12) sont différentes dimensionnellement entre elles de manière à réduire une étendue d'une dispersion des couples élastiques d'une partie au moins des spiraux horlogers (1) réalisés dans la même plaquette (22),
**en ce que** le procédé de fabrication comprend en outre une étape (101, 102) qui suit l'étape b) et dans laquelle :
c) à partir de la résine photosensible (16), on réalise un masque sacrificiel (18) sur la plaquette (22) en retirant de la plaquette (22) la résine photosensible (17) ayant été irradiée par le rayonnement (R) à l'étape b) ou la résine photosensible ayant été soustraite au rayonnement (R) à l'étape b) par le masque réutilisable corrigé (11)
et **en ce qu'**on réalise l'étape d) à l'aide du masque sacrificiel (18).

9. Procédé de fabrication selon la revendication 8, **caractérisé en ce qu'**il comprend une étape préparatoire (500) qui précède l'étape b) et dans laquelle :

a) on élabore le masque réutilisable corrigé (11),

**en ce que** l'étape préparatoire (500) comporte des sous-étapes (520, 540) dans lesquelles :

a1) on réalise une cartographie (30) de degrés de correction à appliquer en des positions différentes sur un plan de plaquette (35) pour réduire une hétérogénéité spatiale d'une gravure réalisée par un dispositif de gravure,
a2) on réalise le masque réutilisable corrigé (11) de telle manière que les fenêtres (12) soient dimensionnées en fonction de la cartographie (30) réalisée à la sous-étape a1),

et **en ce que**, dans la sous-étape a2), on réalise le masque réutilisable corrigé (11) de telle manière que, en plus d'être dimensionnées en fonction de la cartographie (30) réalisée à la sous-étape a1), les fenêtres (12) soient dimensionnées pour qu'à l'étape d), les spiraux horlogers (1) soient réalisés selon des dimensions supérieures aux dimensions nécessaires pour l'obtention du lot de spiraux horlogers (1) dont les couples élastiques ont la moyenne ($M_3$, $M_4$, $M_5$) dans la plage prédéterminée (P).

10. Procédé de fabrication de spiraux horlogers (1) dans une plaquette (22), comprenant une étape (100) dans laquelle :

b) entre au moins une source émettant un rayonnement (R) et une résine photosensible (16) portée par une face de la plaquette (22), un masque réutilisable (11) stoppe au moins une partie du rayonnement (R) sauf au niveau de zones comprenant plusieurs fenêtres (12) qui définissent les contours des spiraux horlogers (1) et que comporte ce masque réutilisable,
**caractérisé en ce que** le masque réutilisable (11) est un masque réutilisable corrigé **en ce qu'**au moins une partie des fenêtres (12) sont différentes dimensionnellement entre elles de manière à réduire une étendue d'une dispersion des couples élastiques d'une partie au moins des spiraux horlogers (1) réalisés dans la même plaquette (22).

11. Procédé de fabrication selon la revendication 10, **caractérisé en ce qu'**il comprend une étape préparatoire (500) qui précède l'étape b) et dans laquelle :

a) on élabore le masque réutilisable corrigé (11).

12. Procédé de fabrication selon la revendication 11, **caractérisé en ce que** l'étape préparatoire (500) comporte des sous-étapes (520, 540) dans lesquelles :

a1) on réalise une cartographie (30) de degrés de correction à appliquer en des positions différentes sur un plan de plaquette (35) pour réduire une hétérogénéité spatiale d'une gravure réalisée par un dispositif de gravure,
a2) on réalise le masque réutilisable corrigé (11) de telle manière que les fenêtres (12) soient dimensionnées en fonction de la cartographie (30) réalisée à la sous-étape a1).

13. Procédé de fabrication selon la revendication 12, **caractérisé en ce que**, dans la sous-étape a1), on effectue ce qui suit :

a11) entre au moins la source et une résine photosensible (16) portée par une face d'une plaquette de test, un masque non corrigé stoppe au moins une partie du rayonnement (R) de la source sauf au niveau de zones comprenant plusieurs fenêtres qui définissent les contours de structures de test et qui sont distantes entre elles au sein du masque non corrigé,
a12) on retire de la plaquette de test la résine photosensible ayant été irradiée par le rayonnement (R) ou la résine photosensible ayant été soustraite au rayonnement (R) par le masque non corrigé,
a13) dans la plaquette de test, on réalise par gravure les structures de test en des positions différentes,
a14) on effectue des mesures pour correction sur les structures de test, on détermine des degrés de correction à partir de ces mesures pour correction et, à ces degrés de correction, on attribue des localisations sur un plan de plaquette (35) en fonction des positions des structures de test.

14. Procédé de fabrication selon la revendication 13, **caractérisé en ce que** les structures de test sont des spiraux horlogers de test.

15. Procédé de fabrication selon la revendication 13 ou 14, **caractérisé en ce que** les fenêtres du masque non corrigé sont dimensionnellement identiques entre elles.

**FIG. 1**

**FIG. 2**

**FIG. 3**

**FIG. 4**

**FIG. 5**

**FIG. 6**

**FIG. 7**

**FIG. 8**

**FIG. 9**

**FIG. 10A**

$l_2$

3

$h_2$

40 $h_1$

e

$l_1$

**FIG. 10B**

$l_2$

3

$h_2$

40

41

e'

**FIG. 10C**

$l_2$

3

$h_2$

40

**FIG. 11A**

P

C3

C4

C5

n

M

classes
0 à 20

classes
20 à 40

classes
40 à 60

classes
60 à 80

**FIG. 11B**

C'4

P

C'5

C'3

n

M

M4

M3

M5

classes
0 à 20

classes
20 à 40

classes
40 à 60

classes
60 à 80

**FIG. 12**

10a

100

101

102

150

110

152

153

1000

200

210

250

522

524

526

528

520

540

500

**FIG. 13**

**FIG. 14A**

**FIG. 14B**

**FIG. 14C**

**FIG. 14D**

**RÉFÉRENCES CITÉES DANS LA DESCRIPTION**

**Documents brevets cités dans la description**

- EP 1422436 A
- EP 3181938 A1
- EP 3181938 A
- EP 2423764 A
- WO 2015113973 A1